# EUROPEAN PATENT APPLICATION

(11) **EP 4 700 776 A1**
(43) Date of publication of application: **25.02.2026**
(21) Application number: 25193695.1
(22) Date of filing: 04.08.2025
(51) Int. Cl.: G11C 16/04, G11C 16/08, G11C 16/10, G11C 16/24, G11C 16/26, G11C 16/32, G11C 16/34, G11C 5/02

(54) **MEMORY DEVICE AND OPERATION METHOD THEREOF**

(30) Priority: 23.08.2024 KR 20240113513
(71) Applicant: Samsung Electronics Co., Ltd., Suwon-si, Gyeonggi-do 16677 (KR)
(72) Inventor: JOE, Sung-Min, Suwon-si, Gyeonggi-do 16677 (KR); MOON, Seunghyun, Suwon-si, Gyeonggi-do 16677 (KR); CHAE, Donghyuk, Suwon-si, Gyeonggi-do 16677 (KR); HONG, Sanggi, Suwon-si, Gyeonggi-do 16677 (KR)
(74) Representative: Kuhnen & Wacker Patent- und Rechtsanwaltsbüro PartG mbB

(57) **Abstract**

A memory device is provided. The memory device includes: a memory cell array including a first string provided in a first layer (CL1) and a second string (STR1_C2) provided in a second layer (CL2) stacked on the first layer (CL1); a page buffer circuit (1140) including a first page buffer (PB1) corresponding to the first string of the first layer and a second page buffer (PB2) corresponding to the second string (STR1_C2) of the second layer; and a control logic circuit (1170) configured to control the first page buffer (PB1) and the second page buffer (PB2) independently, in a core operation.

## Description

### BACKGROUND

The present disclosure described relates to a semiconductor device.

A memory device is used to store data and may be classified as a volatile memory device or a nonvolatile memory device. As an example of the nonvolatile memory device, a flash memory device may be used in a mobile phone, a digital camera, a portable computer device, a stationary computer device, or other device. As an information communication device supports various functions, a high-capacity and highly-integrated memory device is required. As such, a three-dimensional (3D) nonvolatile memory device which includes a plurality of word lines stacked on a substrate in a vertical direction is being developed. In addition, to provide the 3D nonvolatile memory device, a technology for connecting chips formed on different wafers by using a bonding method is being developed.

### SUMMARY

One or more embodiments provide a memory device implemented by a bonding method with improved reliability of a core operation.

According to an aspect of an embodiment, a memory device includes: a memory cell array including a first string provided in a first layer and a second string provided in a second layer stacked on the first layer; a page buffer circuit including a first page buffer corresponding to the first string of the first layer and a second page buffer corresponding to the second string of the second layer; and a control logic circuit configured to control the first page buffer and the second page buffer independently, in a core operation.

According to another aspect of an embodiment, a memory device includes: a first chip including a first page buffer and a second page buffer; a second chip stacked on the first chip, wherein a first string electrically connected to the first page buffer is provided in the second chip; a third chip stacked on the second chip, wherein a second string electrically connected to the second page buffer is provided in the third chip; and a control logic circuit configured to independently control, in a core operation, the first page buffer and the second page buffer.

According to another aspect of an embodiment, a method of operating a memory device which includes a memory cell array including a first string provided in a first layer and a second string provided in a second layer stacked on the first layer, is provided. The method includes: entering a core operation mode; and independently controlling a first page buffer connected to the first string of the first layer and a second page buffer connected to the second string of the second layer, based on a characteristic difference of the first layer and the second layer.

### BRIEF DESCRIPTION OF DRAWINGS

The above and other aspects and features of the present disclosure will be more clearly understood from the following description of embodiments, taken in conjunction with the accompanying drawings, in which:
FIG. 1 is a block diagram illustrating a data storage device according to an embodiment.
FIG. 2 is a block diagram illustrating a memory device according to an embodiment.
FIG. 3 is a diagram for describing an implementation of a memory device according to an embodiment.
FIG. 4 is a cross-sectional view for conceptually describing an implementation of a memory device according to an embodiment.
FIG. 5A is a circuit diagram illustrating one of a plurality of memory blocks formed in a first cell layer of FIG. 4 according to an embodiment. FIG. 5B is a circuit diagram illustrating one of a plurality of memory blocks formed in a second cell layer of FIG. 4 according to an embodiment.
FIG. 6 is a diagram for describing a pass transistor circuit of FIG. 4 according to an embodiment.
FIG. 7A is a circuit diagram illustrating a first page buffer according to an embodiment.
FIG. 7B is a circuit diagram illustrating a second page buffer according to an embodiment.
FIG. 8 is a flowchart for describing a core operation of a memory device according to an embodiment.
FIGS. 9 to 11 are diagrams for describing an operation condition of a pre-program operation that is differently set for each layer in an erase operation according to an embodiment.
FIG. 12 is a flowchart for describing a pre-program operation performed in an erase operation of a memory device according to an embodiment.
FIGS. 13 and 14 are diagrams for describing a verify operation condition that is differently set for each layer in an erase operation according to an embodiment.
FIG. 15 is a flowchart for describing a verify operation performed in an erase operation of a memory device according to an embodiment.
FIGS. 16 and 17 are diagrams for describing a program operation condition that is differently set for each layer according to an embodiment.
FIG. 18 is a flowchart for describing a program operation of a memory device according to an embodiment.
FIGS. 19 and 20 are diagrams for describing a verify operation condition that is differently set for each layer in a program verify operation according to an embodiment.
FIG. 21 is a flowchart for describing a program verify operation of a memory device according to an embodiment.
FIG. 22 shows a timing diagram in which a hard core operation condition is applied to a first cell layer and a soft core operation condition is applied to a second cell layer, in a read operation according to an embodiment.
FIG. 23 is a flowchart for describing a read operation of a memory device according to an embodiment.
FIG. 24 is a cross-sectional view for conceptually describing implementation of a memory device according to an embodiment.
FIG. 25 is a diagram for describing a pass transistor circuit according to an embodiment.
FIG. 26 is a timing diagram illustrating an example of a gate-induced drain leakage (GIDL) erase operation in which a floating time is changed such that a layer-specific characteristic difference is compensated for according to an embodiment.
FIG. 27 is a flowchart for describing a read operation of a memory device according to an embodiment.

### DETAILED DESCRIPTION

Below, embodiments will be described with reference to the accompanying drawings. Like components are denoted by like reference numerals throughout the specification, and repeated descriptions thereof are omitted. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. Embodiments described herein are example embodiments, and thus, the present disclosure is not limited thereto, and may be realized in various other forms. Each embodiment provided in the following description is not excluded from being associated with one or more features of another example or another embodiment also provided herein or not provided herein but consistent with the present disclosure.

### [Data Storage Device Compensating for Difference between Characteristics of Cells Formed in Different Layers]

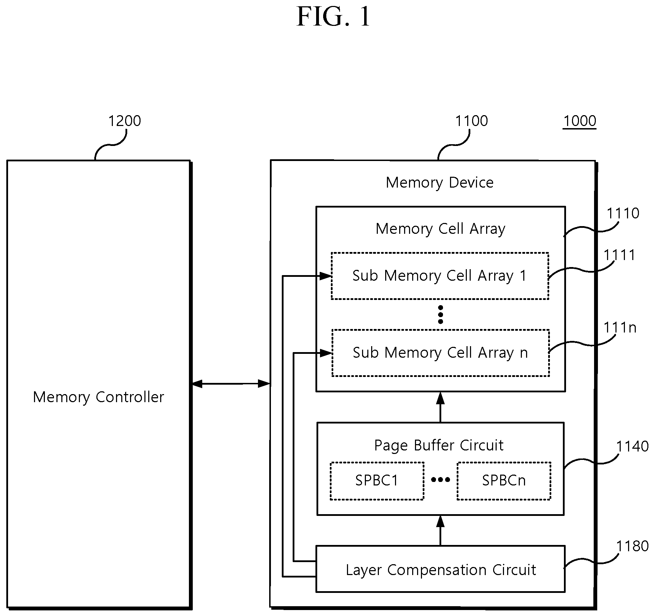

FIG. 1 is a block diagram illustrating a data storage device 1000 according to an embodiment.

The data storage device 1000 according to an embodiment may include a memory device 1100, and a memory cell array 1110 of the memory device 1100 may include memory cells formed in different layers. The layers may be formed through different wafers, and the layers may have therefore characteristics that are different from each other. To compensate for a characteristic difference of the different layers, in a core operation, the memory device 1100 may independently control a page buffer for each layer or may independently control a word line except for a main word line for each layer. Accordingly, the reliability of the core operation of the memory device 1100 may be improved.

Referring to FIG. 1, the data storage device 1000 may include the memory device 1100 and a memory controller 1200, and the memory device 1100 may include the memory cell array 1110, a page buffer circuit 1140, and a layer compensation circuit 1180.

The memory device 1100 may receive an address signal, a command signal, and user data from the memory controller 1200. The memory device 1100 may store the user data, based on the address signal and the command signal. Also, the memory device 1100 may perform an erase operation on the stored data. for example, the memory device 1100 may perform a gate-induced drain leakage (GIDL) erase operation in which an erase voltage is applied through a common source line or a bit line.

The memory cell array 1110 may include a plurality of sub memory cell arrays 1111 to 111n. Each of the plurality of sub memory cell arrays 1111 to 111n may include a plurality of memory cells, and each of the plurality of memory cells may store data.

In an embodiment, the plurality of sub memory cell arrays 1111 to 111n may be respectively formed on different wafers. For example, the plurality of sub memory cell arrays 1111 to 111n may be respectively formed in different chips, and chips where sub memory cell arrays are formed may be connected to each other by the bonding method. Accordingly, the memory cell array 1110 may be formed to include a plurality of layers.

The page buffer circuit 1140 may be connected to the memory cell array 1110 through bit lines. The page buffer circuit 1140 may include a plurality of page buffers, and each page buffer may temporarily store data to be programmed at the corresponding page or data read from the corresponding page.

In an embodiment, the page buffer circuit 1140 may include a plurality of sub page buffer circuits SPBC1 to SPBCn. The plurality of sub page buffer circuits SPBC1 to SPBCn may respectively correspond to the plurality of sub memory cell arrays 1111 to 111n. In the core operation, each of the plurality of sub page buffer circuits SPBC1 to SPBCn may be independently controlled and may independently perform the core operation. In an embodiment, the core operation may refer to at least one of an erase operation, a program operation, a verify operation, or a read operation.

For example, the first sub page buffer circuit SPBC1 may include a plurality of page buffers, and the page buffers of the first sub page buffer circuit SPBC1 may be electrically connected to the bit lines of the first sub memory cell array 1111, respectively. Also, for example, the n-th sub page buffer circuit SPBCn may include a plurality of page buffers, and the page buffers of the n-th sub page buffer circuit SPBCn may be electrically connected to the bit lines of the n-th sub memory cell array 111n, respectively. In the core operation, the first sub page buffer circuit SPBC1 and the n-th sub page buffer circuit SPBCn may be independently controlled, and an operation condition of the first sub page buffer circuit SPBC1 and an operation condition of the n-th sub page buffer circuit SPBCn may be set to be different from each other.

The layer compensation circuit 1180 may be electrically connected to the page buffer circuit 1140 and/or the memory cell array 1110. Based on a cell characteristic of each layer, the layer compensation circuit 1180 may set an operation condition of the core operation differently for each layer.

In an embodiment, the layer compensation circuit 1180 may independently control the sub page buffer circuit SPBC corresponding to each layer, based on the cell characteristic of each layer. For example, the layer compensation circuit 1180 may set a core operation condition, such as a voltage level of a bit line, a bit line voltage application time, or a sensing time, differently for each layer. Accordingly, a characteristic difference of memory cells formed on different layers, a word line loading difference, and/or a bit line loading difference may be compensated for.

Alternatively, in an embodiment, the layer compensation circuit 1180 may independently control a word line except for a main word line for each layer, based on the cell characteristic of each layer. In an embodiment, the main word line may refer to a word line connected to memory cells storing data, and a word line except for the main word line may refer to a GIDL line, a string selection line, a ground selection line, a dummy word lines, etc., to be described below. Accordingly, in the GIDL erase operation, a floating time of the string selection line or the like may be set differently for each layer. Accordingly, a characteristic difference of memory cells formed on different layers, a word line loading difference, and/or a bit line loading difference may be compensated for.

As described above, in the core operation, the memory device 1100 according to an embodiment may independently control a page buffer for each layer or may independently control a word line except for a main word line for each layer. Accordingly, the reliability of the core operation of the memory device 100 may be improved.

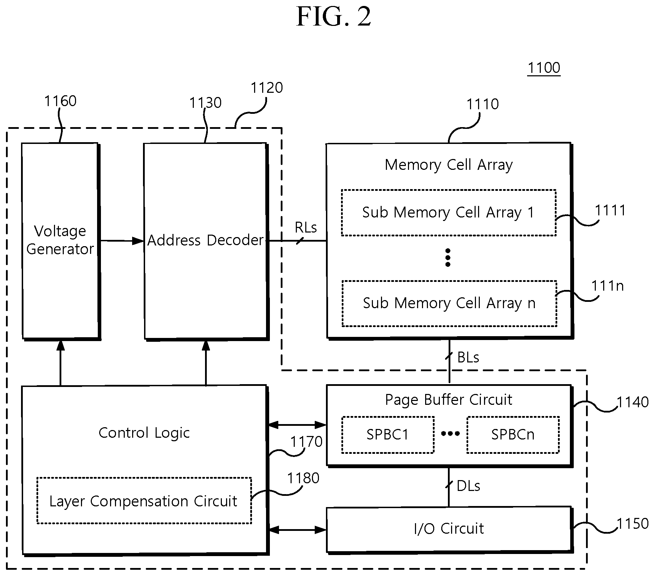

FIG. 2 is a block diagram illustrating an example of the memory device 1100 of FIG. 1.

Referring to FIG. 2, the memory device 1100 may include the memory cell array 1110 and a peripheral circuit 1120, and the peripheral circuit 1120 may include an address decoder (i.e., an address decoder circuit) 1130, the page buffer circuit 1140, an input/output circuit 1150, a voltage generator (i.e., an voltage generation circuit) 1160, and control logic (i.e., an control logic circuit) 1170.

The memory cell array 1110 may include a plurality of memory blocks. Each of the memory blocks may have a two-dimensional structure or a three-dimensional structure. Memory cells of a memory block with the two-dimensional structure (or a horizontal (or planar) structure) may be formed in a direction parallel to a substrate. Memory cells of a memory block with the three-dimensional structure (or a vertical structure) may be formed in a direction perpendicular to the substrate.

The memory cell array 1110 may include the plurality of sub memory cell arrays 1111 to 111n. The plurality of sub memory cell arrays 1111 to 111n may be respectively formed on different wafers. For example, the plurality of sub memory cell arrays 1111 to 111n may be respectively formed in different chips, and chips where sub memory cell arrays are formed may be connected to each other by the bonding method.

The address decoder 1130 may be connected to the memory cell array 1110 through row lines RLs. The row lines RLs may include string selection lines, ground selection lines, word lines, dummy word lines, and GIDL lines.

The page buffer circuit 1140 may be connected to the memory cell array 1110 through bit lines BLs. The page buffer circuit 1140 may temporarily store data to be programed at a selected page or data read from the selected page.

The page buffer circuit 1140 may include the plurality of sub page buffer circuits SPBC1 to SPBCn. The plurality of sub page buffer circuits SPBC1 to SPBCn may respectively correspond to the plurality of sub memory cell arrays 1111 to 111n. In the core operation, each of the plurality of sub page buffer circuits SPBC1 to SPBCn may be independently controlled and may independently perform the core operation. In an embodiment, to compensate for characteristic differences of the layers, the operation condition in the core operation of each page buffer circuit may be differently set.

The input/output circuit 1150 may be connected to the page buffer circuit 1140 through data lines DLs internally and may be connected to the memory controller 1200 (refer to FIG. 1) through input/output lines externally.

The voltage generator 1160 may generate various voltages necessary for the memory device 1100 to operate. For example, the voltage generator 1160 may be configured to generate various voltages, which are provided to the row lines RLs, the bit lines BLs, or a common source line depending on the operation of the memory device 1100. For example, the voltage generator 1160 may be configured to generate a plurality of program voltages, a plurality of program verify voltages, a plurality of pass voltages, a plurality of read voltages, a plurality of read pass voltages, and a plurality of erase voltages.

The control logic 1170 may control all the operations of the memory device 1100 in response to a command and an address provided from the memory controller 1200. The control logic 1170 may include the layer compensation circuit 1180 which sets a condition of the core operation differently for each layer.

The layer compensation circuit 1180 may be electrically connected to the page buffer circuit 1140 and/or the memory cell array 1110. Based on a cell characteristic of each layer, the layer compensation circuit 1180 may set an operation condition of the core operation differently for each layer.

For example, the layer compensation circuit 1180 may independently control the sub page buffer circuit SPBC corresponding to each layer, based on the characteristic of each layer. Alternatively, for example, the layer compensation circuit 1180 may independently control a word line except for a main word line for each layer, based on the characteristic of each layer. Accordingly, the characteristic differences of the layers may be compensated for.

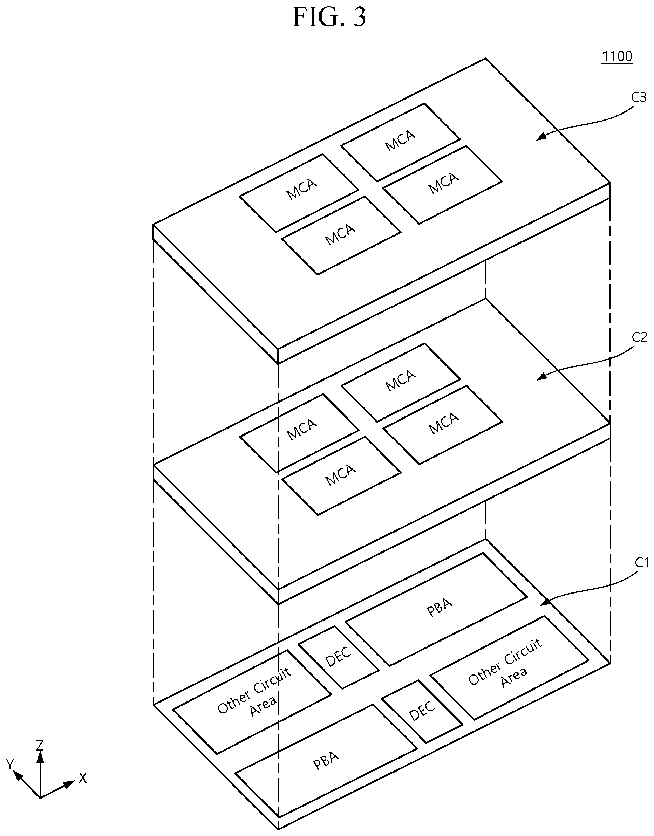

FIG. 3 is a diagram for describing implementation of the memory device 1100 of FIG. 2 according to an embodiment. For convenience of description, in FIG. 3, it is assumed that the memory device 1100 is implemented by bonding three chips and a memory cell array is implemented with two chips.

Referring to FIG. 3, the memory device 1100 may include first, second, and third chips C1, C2, and C3 stacked in the vertical direction. The first chip C1 may include the peripheral circuit 1120 of FIG. 2, the second chip C2 may include the first sub memory cell array 1111 of FIG. 2, and the third chip C3 may include a second sub memory cell array. The first chip C1 and the second chip C2 may be connected to each other by the bonding method, and the second chip C2 and the third chip C3 may be connected to each other by the bonding method.

The first chip C1 may include circuit areas, including a row decoder area DEC, a page buffer area PBA, and another circuit area. The address decoder 1130 of FIG. 2 may be disposed in the row decoder area DEC, and the page buffer circuit 1140 of FIG. 2 may be disposed in the page buffer area PBA. Also, the control logic 1170, the layer compensation circuit 1180, and/or the voltage generator 1160 of FIG. 2 may be disposed in the other circuit area. For example, the input/output circuit 1150 of FIG. 2 may be disposed in the other circuit area.

The second chip C2 may include a memory cell array MCA. The first sub memory cell array 1111 of FIG. 2 may be disposed in the memory cell array MCA of the second chip C2.

The third chip C3 may include a memory cell array MCA. The second sub memory cell array may be disposed in the memory cell array MCA of the third chip C3.

The first chip C1, the second chip C2, and the third chip C3 may be manufactured by using different wafers and may be bonded to each other. For this reason, a cell characteristic of memory cells disposed in the second chip C2 may be different from a cell characteristic of memory cells of the third chip C3. For example, a speed of the core operation of the memory cells disposed in the second chip C2 may be different from a speed of the core operation of the memory cells disposed in the third chip C3.

Also, a length of a word line electrically connecting the memory cells disposed in the second chip C2 to the address decoder 1130 disposed in the first chip C1 may be different from a length of a word line electrically connecting the memory cells disposed in the third chip C3 to the address decoder 1130 disposed in the first chip C1. The difference between the word line lengths may result in different loading characteristics.

Also, a length of a bit line electrically connecting the memory cells disposed in the second chip C2 to the page buffer circuit 1140 disposed in the first chip C1 may be different from a length of a bit line electrically connecting the memory cells disposed in the third chip C3 to the page buffer circuit 1140 disposed in the first chip C1. The difference between the bit line lengths may result in different loading characteristics.

To compensate for a chip-specific cell characteristic difference, a chip-specific word line loading characteristic difference, and/or a chip-specific bit line loading characteristic difference, based on a characteristic of each layer, the layer compensation circuit 1180 according to an embodiment may independently control the sub page buffer circuit SPBC corresponding to each layer or may independently control a word line except for a main word line for each layer. Accordingly, a characteristic difference of memory cells formed on different layers, a word line loading difference, and/or a bit line loading difference may be compensated for. This may improve reliability of the core operation.

In an embodiment, the description is given with reference to FIG. 3 as three chips are bonded to each other. However, this is provided as an example, and embodiments are not limited thereto. According to an embodiment, "N" different chips (N being a natural number of 3 or more) may be bonded to each other. For example, the memory cell array 1110 of FIG. 2 may be implemented by bonding three or more different chips. Alternatively, for example, the peripheral circuit 1120 of FIG. 2 may be implemented by bonding two or more different chips. In the specification, for convenience of description, an embodiment in which three chips are bonded as illustrated in FIG. 3 will be described.

Below, first, examples of improving the reliability of the core operation by independently controlling a page buffer for each layer will be described in detail. Next, examples of improving the reliability of the core operation by independently controlling a word line except for a main word line for each layer will be described in detail.

### [Page Buffer Controlled Independently for Each Layer]

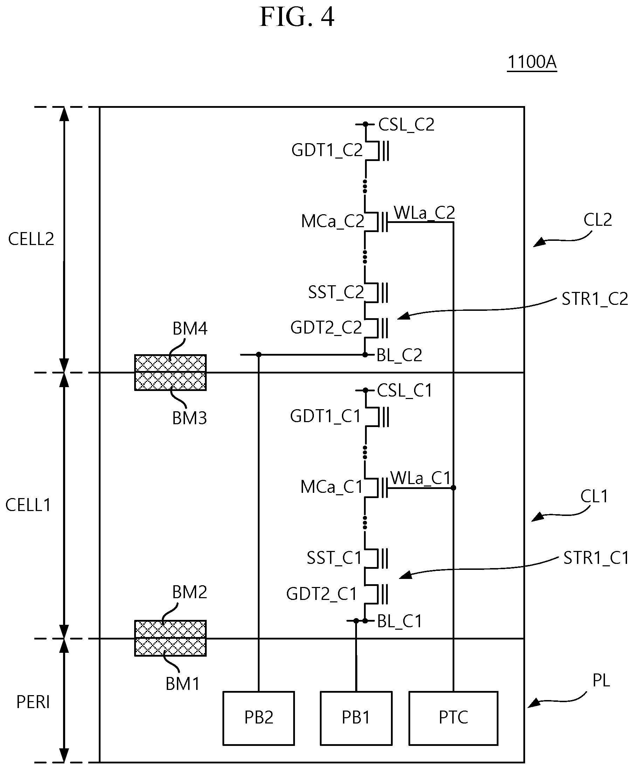

FIG. 4 is a cross-sectional view for conceptually describing implementation of a memory device, such as the memory device of FIG. 2, according to an embodiment. As in the above description given with reference to FIG. 3, it is assumed that a memory device 1100A of FIG. 4 is implemented by bonding three chips and a memory cell array is implemented with two chips. Also, for convenience of description, one of a plurality of strings of each cell area is illustrated in FIG. 4 as an example.

Referring to FIG. 4, when viewed in the vertical direction, the memory device 1100A may include a peri layer PL, a first cell layer CL1, and a second cell layer CL2.

The peri layer PL may correspond to the first chip C1 of FIG. 3, and the peripheral circuit 1120 of FIG. 2 may be formed in the peri layer PL. For example, a pass transistor circuit PTC, a first page buffer PB1, and a second page buffer PB2 may be formed in the peri layer PL. In an embodiment, the pass transistor circuit PTC may be included in the address decoder 1130 of FIG. 2. Also, the first page buffer PB1 may be included in the first sub page buffer circuit SPBC1 of FIG. 2. The second page buffer PB2 may be included in the second sub page buffer circuit. According to an embodiment, the peri layer PL may be referred to as a "peripheral circuit area PERI".

The peri layer PL and the first cell layer CL1 may be connected to each other by the bonding method. For example, a first bonding metal BM1 may be disposed on an upper portion of the peri layer PL, and a second bonding metal BM2 may be disposed on a lower portion of the first cell layer CL1. The peri layer PL and the first cell layer CL1 may be connected to each other by bonding the first bonding metal BM1 and the second bonding metal BM2.

The first cell layer CL1 may correspond to the second chip C2 of FIG. 3, and the first sub memory cell array 1111 of FIG. 2 may be formed in the first cell layer CL1. For example, the first sub memory cell array 1111 may include a first string STR1_C1, and the first string STR1_C1 may be in the first cell layer CL1 and may extend in the vertical direction.

The first string STR1_C1 of the first cell layer CL1 may include a plurality of transistors GDT1_C1, GDT2_C1, and SST_C1 and a plurality of memory cells MCa_C1 ("a" in "MCa_C1" being an integer). A first end of the first string STR1_C1 of the first cell layer CL1 may be connected to a bit line BL_C1, and a second end thereof may be connected to a common source line CSL_C1. According to an embodiment, the first cell layer CL1 may be referred to as a "first cell area CELL1".

The first cell layer CL1 and the second cell layer CL2 may be connected to each other by the bonding method. For example, a third bonding metal BM3 may be disposed on an upper portion of the first cell layer CL1, and a fourth bonding metal BM4 may be disposed on a lower portion of the second cell layer CL2. The first cell layer CL1 and the second cell layer CL2 may be connected to each other by bonding the third bonding metal BM3 and the fourth bonding metal BM4.

The second cell layer CL2 may correspond to the third chip C3 of FIG. 3, and the second sub memory cell array may be formed in the second cell layer CL2. For example, the second sub memory cell array may include a first string STR1_C2, and the first string STR1_C2 may be formed in the second cell layer CL2 and may extend in the vertical direction.

The first string STR1_C2 of the second cell layer CL2 may include a plurality of transistors GDT1_C2, GDT2_C2, and SST_C2 and a plurality of memory cells MCa_C2 ("a" being an integer). A first end of the first string STR1_C2 of the second cell layer CL2 may be connected to a bit line BL_C2, and a second end thereof may be connected to a common source line CSL_C2. According to an embodiment, the second cell layer CL2 may be referred to as a "second cell area CELL2".

In an embodiment, a word line of the first cell layer CL1 and a word line of the second cell layer CL2 may be simultaneously controlled.

For example, the memory cell MCa_C1 of the first cell layer CL1 may be connected to a word line WLa_C1, and the word line WLa_C1 of the first cell layer CL1 may be connected to the pass transistor circuit PTC of the peri layer PL. Also, for example, the memory cell MCa_C2 of the second cell layer CL2 may be connected to a word line WLa_C2, and the word line WLa_C2 of the second cell layer CL2 may be connected to the pass transistor circuit PTC of the peri layer PL. The pass transistor circuit PTC of the peri layer PL may simultaneously drive the word line WLa_C1 of the first cell layer CL1 and the word line WLa_C2 of the second cell layer CL2.

In this case, the word line WLa_C1 of the first cell layer CL1 and the word line WLa_C2 of the second cell layer CL2 are incapable of being independently controlled. Thus, it may be impossible to compensate for a cell characteristic difference, a word line loading difference, and/or a bit line loading difference of the first cell layer CL1 and the second cell layer CL2 by using a method of controlling a word line.

In an embodiment, the bit line BL_C1 of the first cell layer CL1 may be connected to the first page buffer PB1, and the bit line BL_C2 of the second cell layer CL2 may be connected to the second page buffer PB2. In this case, in the core operation, each of the first page buffer PB1 and the second page buffer PB2 may be independently controlled.

For example, a core operation condition such as a voltage level of the bit line BL_C1 of the first cell layer CL1 controlled through the first page buffer PB1, a voltage application time of the bit line BL_C1, or a sensing time may be set to be different from a core operation condition such as a voltage level of the bit line BL_C2 of the second cell layer CL2 controlled through the second page buffer PB2, a voltage application time of the bit line BL_C2, or a sensing time may be differently set. Accordingly, it may be possible to compensate for a cell characteristic difference, a word line loading difference, and/or a bit line loading difference of the first cell layer CL1 and the second cell layer CL2 in the core operation.

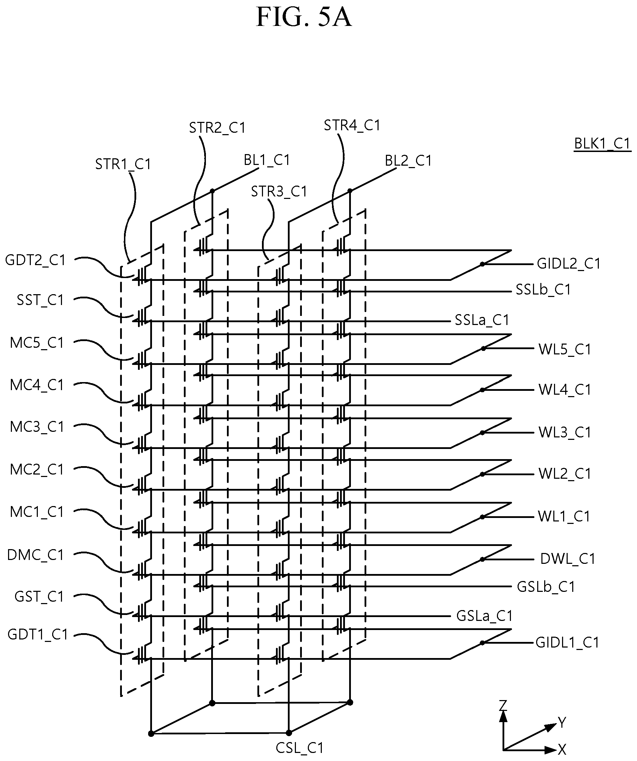

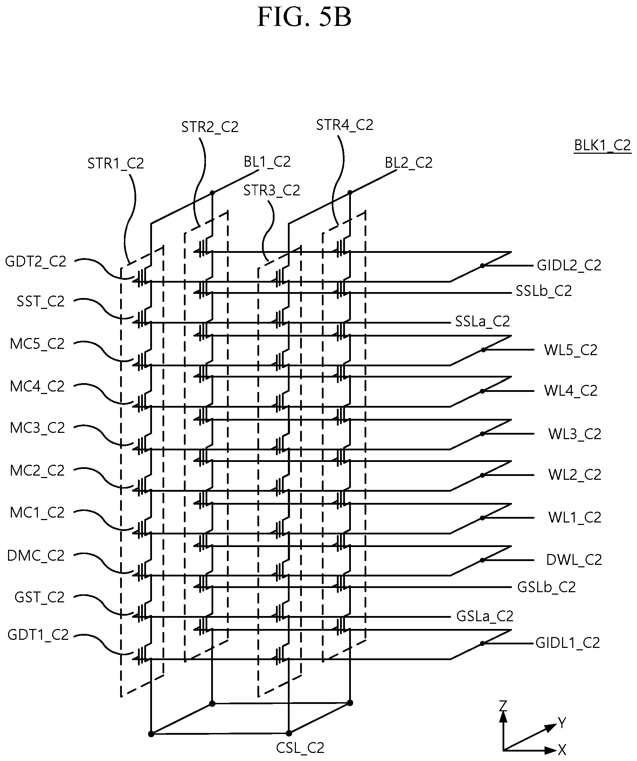

FIG. 5A is a circuit diagram illustrating one of a plurality of memory blocks formed in the first cell layer CL1 of FIG. 4 according to an embodiment. FIG. 5B is a circuit diagram illustrating one of a plurality of memory blocks formed in the second cell layer CL2 of FIG. 4 according to an embodiment. For convenience of description, it is assumed that four strings are included in one memory block and each string includes five memory cells.

Referring to FIG. 5A, a memory block BLK1_C1 of the first cell layer CL1 may include a plurality of strings STR1_C1 to STR4_C1 vertically stacked on a substrate. The plurality of strings STR1_C1 to STR4_C1 may be disposed in a first direction (i.e., an X-axis direction) and a second direction (i.e., a Y-axis direction).

Strings belonging to the same column from among the plurality of strings STR1_C1 to STR4_C1 may be connected to the same bit line. For example, the first and second strings STR1_C1 and STR2_C1 may be connected to a first bit line BL1_C1, and the third and fourth strings STR3_C1 and STR4_C1 may be connected to a second bit line BL2_C1.

Each of the plurality of strings STR1_C1 to STR4_C1 may include a plurality of cell transistors. Each of the plurality of cell transistors may include a charge trap flash (CTF) memory cell, but embodiments are not limited thereto. The plurality of cell transistors may be stacked in a third direction (i.e., a Z-axis direction).

The plurality of strings STR1_C1 to STR4_C1 may be connected in common to the common source line CSL_C1. For example, as illustrated in FIG. 5A, the common source line CSL_C1 may be connected in common to lower ends of the plurality of strings STR1_C1 to STR4_C1. However, this is provided as an example. It is sufficient if the common source line CSL_C1 is electrically connected to the lower ends of the strings STR1_C1 to STR4_C1, and embodiments are not limited to the case that the common source line CSL_C1 is physically located at the lower ends of the strings STR1_C1 to STR4_C1. Below, for convenience of description, a structure and a configuration of a string will be described based on the first string STR1_C1.

The plurality of cell transistors may be connected in series between the first bit line BL1_C1 and the common source line CSL_C1. For example, the plurality of cell transistors may include GIDL transistors GDT1_C1 and GDT2_C1, a string selection transistor SST_C1, memory cells MC1_C1 to MC5_C1, a dummy memory cell DMC_C1, and a ground selection transistor GST_C1.

The GIDL transistors GDT1_C1 and GDT2_C1 may be disposed at a lower end and an upper end of the string STR1_C1. For example, the first GIDL transistor GDT1_C1 may be connected to the common source line CSL_C1 at the lower end of the string STR1_C1. The second GIDL transistor GDT2_C1 may be connected to the first bit line BL1_C1 at the upper end of the string STR1_C1. A gate of the first GIDL transistor GDT1_C1 may be connected to a first GIDL line GIDL1_C1, and a gate of the second GIDL transistor GDT2_C1 may be connected to a second GIDL line GIDL2_C1. However, this is provided as an example. According to an embodiment, the GIDL transistor may be provided only at the upper end of the string STR1_C1, or the GIDL transistor may be provided only at the lower end of the string STR1_C1.

One string selection transistor SST_C1 may be provided between the fifth memory cell MC5_C1 and the second GIDL transistor GDT2_C1. A gate of the string selection transistor SST_C1 may be connected to a string selection line SSLa_C1. However, this is provided as an example. According to an embodiment, a plurality of string selection transistors which are connected in series may be provided between the fifth memory cell MC5_C1 and the second GIDL transistor GDT2_C1.

One ground selection transistor GST_C1 may be provided between the dummy memory cell DMC_C1 and the first GIDL transistor GDT1_C1. A gate of the ground selection transistor GST_C1 may be connected to a ground selection line GSLa_C1. However, this is provided as an example. According to an embodiment, a plurality of ground selection transistors which are connected in series may be provided between the dummy memory cell DMC_C1 and the first GIDL transistor GDT1_C1.

The first to fifth memory cells MC1_C1 to MC5_C1 may be connected in series between the string selection transistor SST_C1 and the dummy memory cell DMC_C1. Gates of the first to fifth memory cells MC1_C1 to MC5_C1 may be respectively connected with first to fifth word lines WL1_C1 to WL5_C1.

One dummy memory cell DMC_C1 may be provided between the first memory cell MC1_C1 and the first GIDL transistor GDT1_C1. A gate of dummy memory cell DMC_C1 may be connected to a dummy word line DWL_C1. However, this is provided as an example. According to an embodiment, a plurality of dummy memory cells that are connected in series may be provided between the first memory cell MC1_C1 and the first GIDL transistor GDT1_C1. Alternatively, an additional dummy memory cell may be provided between the string selection transistor SST_C1 and the fifth memory cell MC5_C1.

Referring to FIG. 5B, a memory block BLK1_C2 of the second cell layer CL2 may include a plurality of strings STR1_C2 to STR4_C2 vertically stacked on a substrate. A configuration and arrangement of each of the plurality of strings STR1_C2 to STR4_C2 are similar to those described with reference to FIG. 5A, and thus, repeated description will be omitted to avoid redundancy.

In an embodiment, the number of dummy word lines of the first cell layer CL1 may be equal to the number of dummy word lines of the second cell layer CL2.

In detail, due to a characteristic difference in the process of manufacturing the first cell layer CL1 and the second cell layer CL2, for a stable operation, the number of dummy word lines of the first cell layer CL1 may be different from the number of dummy word lines of the second cell layer CL2. For example, for the stable operation, the first cell layer CL1 may require at least two dummy word lines, and the second cell layer CL2 may require at least three dummy word lines.

In this case, the number of dummy word lines of the first cell layer CL1 may be set to be equal to that of the second cell layer CL2 whose characteristic is bad. That is, according to an embodiment, because a main word line of the first cell layer CL1 and a main word line of the second cell layer CL2 are connected to each other, the number of dummy word lines of the first cell layer CL1 may be set to be equal to the number of dummy word lines of the second cell layer CL2. Accordingly, a memory device may stably operate regardless of a cell characteristic difference of the first cell layer CL1 and the second cell layer CL2. In addition, according to an embodiment, each of the dummy word line of the first cell layer CL1 and the dummy word line of the second cell layer CL2 may be independently driven, and thus, the memory device may stably operate regardless of a cell characteristic difference for each layer.

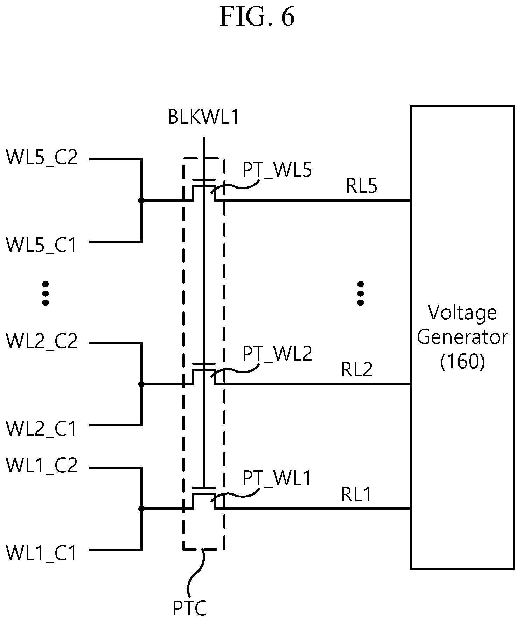

FIG. 6 is a diagram for describing the pass transistor circuit PTC of FIG. 4 according to an embodiment. For convenience, as in the above description given with reference to FIGS. 4 to 5B, it is assumed that a string of the first cell layer CL1 is connected to the first to fifth word lines WL1_C1 to WLS_C1 and a string of the second cell layer CL2 is connected to the first to fifth word lines WL1_C2 to WL5_C2.

Referring to FIGS. 4 to 6, the pass transistor circuit PTC may include first to fifth pass transistors PT_WL1 to PT_WL5. Gates of the first to fifth pass transistors PT_WL1 to PT_WL5 may be connected to a block word line BLKWL1.

A first end of the first pass transistor PT_WL1 may be connected to the first word line WL1_C1 of the first cell layer CL1 and the first word line WL1_C2 of the second cell layer CL2. A second end of the first pass transistor PT_WL1 may be connected to a first row line RL1. In response to the voltage level of the block word line BLKWL1, the first pass transistor PT_WL1 may provide a voltage received from a voltage generator 160 to each of the first word line WL1_C1 of the first cell layer CL1 and the first word line WL1_C2 of the second cell layer CL2.

As in the above description, a first end of the second pass transistor PT_WL2 may be connected to the second word line WL2_C1 of the first cell layer CL1 and the second word line WL2_C2 of the second cell layer CL2. A second end of the second pass transistor PT_WL2 may be connected to a second row line RL2. Likewise, a first end of the fifth pass transistor PT_WL5 may be connected to the fifth word line WL5_C1 of the first cell layer CL1 and the fifth word line WL5_C2 of the second cell layer CL2. A second end of the fifth pass transistor PT_WL5 may be connected to a fifth row line RL5.

According to the above description, the word line of the first cell layer CL1 and the word line of the second cell layer CL2 corresponding thereto may be simultaneously driven by the same pass transistor. In this case, compared to the case of individually driving the word line of the first cell layer CL1 and the word line of the second cell layer CL2, the area for implementing the pass transistor circuit may be reduced.

Because the word line of the first cell layer CL1 and the word line of the second cell layer CL2 corresponding thereto are simultaneously driven by the same pass transistor, a layer-specific characteristic difference is incapable of being compensated for through a word line. According to an embodiment, the layer-specific characteristic difference may be compensated for through a layer-specific independent control of a page buffer.

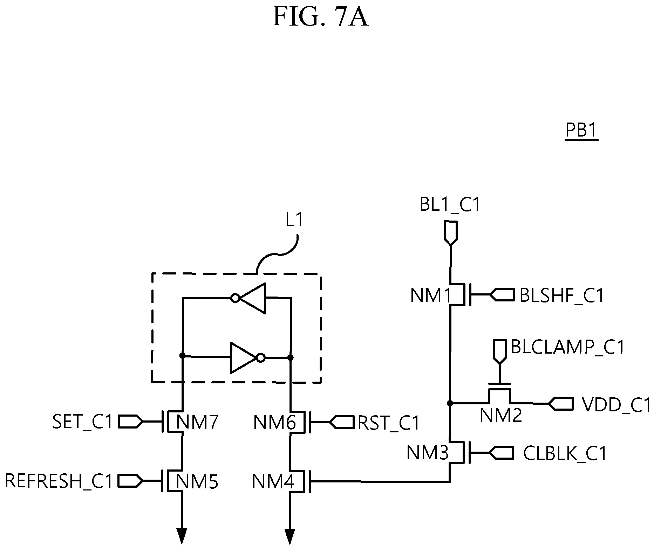

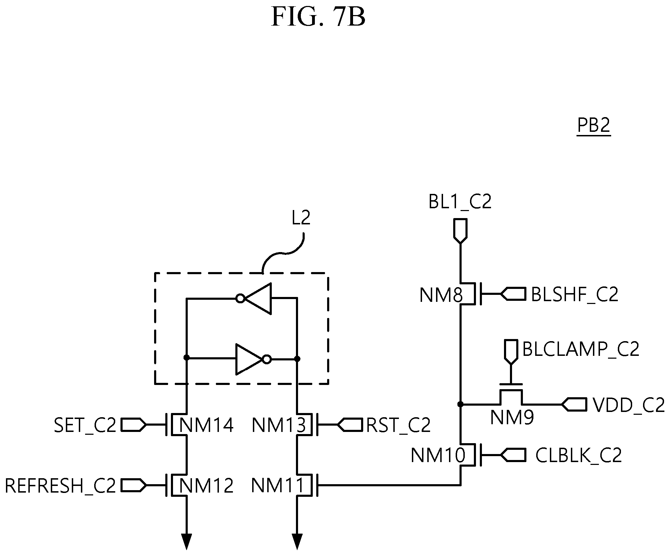

FIG. 7A is a circuit diagram illustrating an example of the first page buffer PB1 of FIG. 4 according to an embodiment, and FIG. 7B is a circuit diagram illustrating an example of the second page buffer PB2 of FIG. 4 according to an embodiment.

First, referring to FIG. 7A, the first page buffer PB1 may be electrically connected to the first bit line BL1_C1 of the first cell layer CL1.

The first page buffer PB1 may include a plurality of transistors NM1 to NM7 and a first latch L1.

The first transistor NM1 may be connected to the first bit line BL1_C1 of the first cell layer CL1. In response to a bit line shut-off signal BLSHF_C1, the first transistor NM1 may be electrically connected or disconnected to or from the first bit line BL1_C1.

The second transistor NM2 may receive a power supply voltage VDD_C1. In response to a bit line clamping control signal BLCLAMP_C1, the second transistor NM2 may provide the power supply voltage VDD_C1 to the first bit line BL1_C1 or may block the power supply voltage VDD_C1 from being provided to the first bit line BL1 _C1. As described above, according to an embodiment, the voltage level and/or the application time of the power supply voltage VDD_C1 may vary depending on a type of the core operation, a cell characteristic of a relevant layer, etc.

The third transistor NM3 may be turned on or turned off in response to a bit line connection control signal CLBLK_C1. Accordingly, the sensing operation may be performed by selectively connecting the first bit line BL1_C1 of STR1_C1 and a first sensing node according to the first bit line connection control signal CLBLK _C1. As described above, according to an embodiment, the application time of the bit line connection control signal CLBLK_C1 may vary depending on a type of the core operation, a cell characteristic of a relevant layer, etc.

The fourth transistor NM4 and the sixth distance NM6 may be connected in series. A gate of the fourth transistor NM4 may be connected to a first end of the third transistor NM3, and a gate of the sixth transistor NM6 may be connected to a bit line reset signal RST_C1.

The fifth transistor NM5 and the seventh distance NM7 may be connected in series. A gate of the fifth transistor NM5 may be connected to a bit line refresh signal REFRESH_C1, and a gate of the seventh transistor NM7 may be connected to a bit line setup signal SET_C1.

In the read operation or the verify operation, the first latch L1 may store data to be stored in a memory cell through the first bit line BL1_C1 or a sensing result of a threshold voltage of a memory cell. The latch L1 may provide a sensing node. Alternatively, according to an embodiment, in the program operation, the first latch L1 may be utilized to provide a bit line voltage or a program inhibit voltage to the first bit line BL1_C1.

First, referring to FIG. 7B, the second page buffer PB2 may be electrically connected to the first bit line BL1_C2 of the second cell layer CL2.

The second page buffer PB2 may include a plurality of transistors NM8 to NM14 and a second latch L2. A configuration and an operation of the second page buffer PB2 is similar to those of the first page buffer PB1, and thus, repeated description will be omitted to avoid redundancy.

In an embodiment, in the core operation, each of the first page buffer PB1 and the second page buffer PB2 may be independently controlled.

For example, in the same core operation, the application time and/or the voltage level of at least one of the bit line shut-off signal BLSHF_C1, the bit line clamping control signal BLCLAMP_C1, the power supply voltage VDD_C1, the bit line connection control signal CLBLK_C1, the bit line setup signal SET_C1, the bit line reset signal RST_C1, or the bit line refresh signal REFRESH_C1 to be provided to the first page buffer PB1 may be different from the application time and/or the voltage level of at least one of a bit line shut-off signal BLSHF_C2, a bit line clamping control signal BLCLAMP_C2, a power supply voltage VDD_C2, a bit line connection control signal CLBLK_C2, a bit line setup signal SET_C2, a bit line reset signal RST_C2, or a bit line refresh signal REFRESH_C2 to be provided to the second page buffer PB2.

In this case, according to an embodiment, each of a generator which generates the bit line shut-off signal BLSHF_C1, the bit line clamping control signal BLCLAMP_C1, the power supply voltage VDD_C1, the bit line connection control signal CLBLK_C1, the bit line setup signal SET_C1, the bit line reset signal RST_C1, or the bit line refresh signal REFRESH_C1 to be provided to the first page buffer PB1 and a generator which generates the bit line shut-off signal BLSHF_C2, the bit line clamping control signal BLCLAMP_C2, the power supply voltage VDD_C2, the bit line connection control signal CLBLK_C2, the bit line setup signal SET_C2, the bit line reset signal RST_C2, or the bit line refresh signal REFRESH_C2 to be provided to the second page buffer PB2 may be independently provided.

As described above, in the core operation, the reliability of the core operation of the memory device may be improved in the core operation by independently controlling each of the first page buffer PB1 connected to the first cell layer CL1 and the second page buffer PB2 connected to the second cell layer CL2.

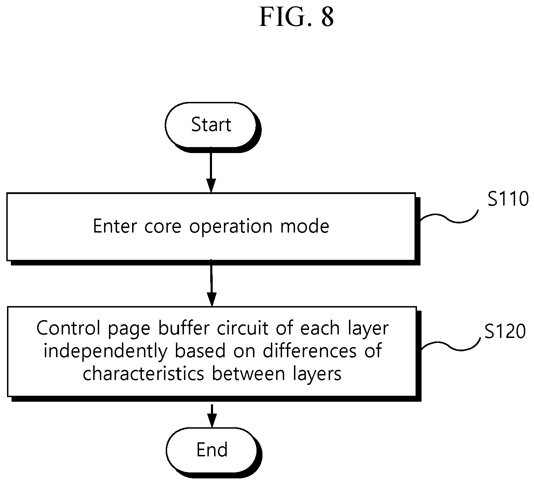

FIG. 8 is a flowchart for describing a core operation of a memory device according to an embodiment.

In operation S110, the memory device may enter a core operation mode (e.g. a pre-program operation mode, an erase verify operation mode, a program operation mode, a program verify operation mode, or a read operation mode).

For example, the memory device may enter a mode for performing the erase operation, the program operation, the verify operation, or the read operation.

In operation S120, the memory device may independently control a page buffer corresponding to each layer, based on a layer-specific cell characteristic difference, a layer-specific word line loading difference, and/or a layer-specific bit line loading difference.

For example, when a cell characteristic of memory cells, such as a speed of the core operation of the memory cells, corresponding to a first layer is better than a cell characteristic of memory cells corresponding to a second layer, a first page buffer corresponding to the first layer may be controlled by using a hard core operation condition, and a second page buffer corresponding to the second layer may be controlled by using a soft core operation condition.

In an embodiment, the hard core operation condition may refer to a condition in which a voltage level of a bit line or an application time of a bit line is set such that the erase operation, the program operation, the verify operation, the read operation, etc., is performed to be relatively slow. The soft core operation condition may refer to a condition in which a voltage level of a bit line or an application time of a bit line is set such that the erase operation, the program operation, the verify operation, the read operation, etc., is performed to be relatively fast. In this regard, the erase operation, the program operation, the verify operation, the read operation may be performed faster in the soft core operation than in the hard core operation.

As described above, the reliability of the core operation of the memory device may be improved by independently controlling a page buffer for each layer.

### [Layer-Specific Control of Operation Condition of Pre-Program in Erase Operation]

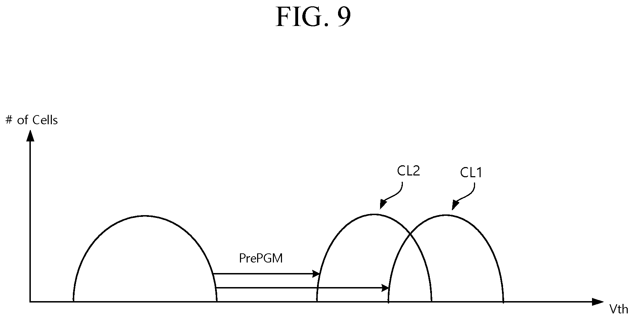

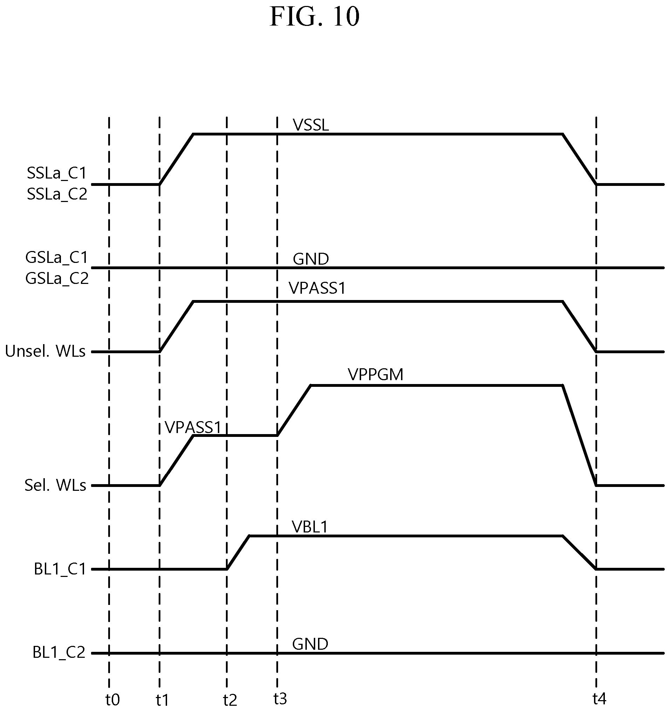

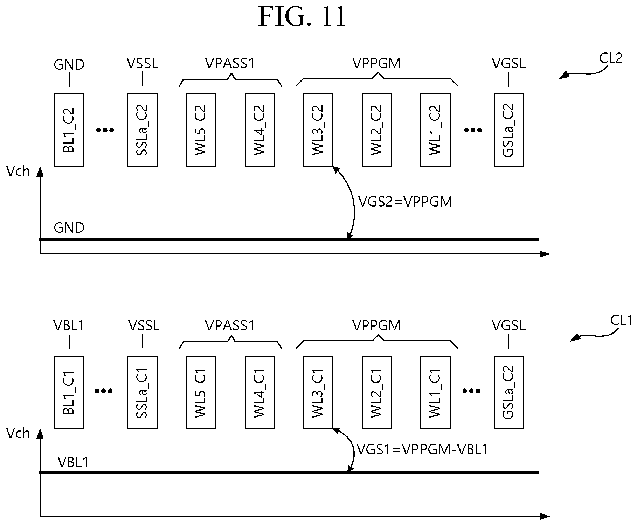

FIGS. 9 to 11 are diagrams for describing an operation condition of a pre-program operation (e.g. in a pre-program operation mode of the control logic 1170) that is differently set for each layer in an erase operation according to an embodiment. In detail, FIG. 9 is a diagram illustrating an example of a cell characteristic difference of the first cell layer CL1 and the second cell layer CL2. FIG. 10 shows an example of a timing diagram in which the hard core operation condition is applied to the first cell layer CL1 and the soft core operation condition is applied to the second cell layer CL2, in the pre-program operation. FIG. 11 is a diagram illustrating an example of a channel voltage Vch when the hard core operation condition is applied to the first cell layer CL1 and the soft core operation condition is applied to the second cell layer CL2.

Referring to FIG. 9, pre-program characteristics of the first cell layer CL1 and the second cell layer CL2 formed on different wafers may be different. For example, as illustrated in FIG. 9, the memory cells of the first cell layer CL1 may be pre-programmed prior to the memory cells of the second cell layer CL2, and in this regard may have different threshold voltages. In this case, the reliability of operation of the memory device may be reduced, or the performance of the memory device may be degraded.

To compensate for the layer-specific characteristic difference, according to an embodiment, in the pre-program operation belonging to the erase operation, the first page buffer PB1 (refer to FIG. 4) corresponding to the first cell layer CL1 may be controlled by using the hard core operation condition, and the second page buffer PB2 (refer to FIG. 4) corresponding to the second cell layer CL2 may be controlled by using the soft core operation condition.

In an embodiment, the description will be given in detail with reference to FIGS. 10 and 11. At a 0-th time point t0, each of the string selection line SSLa_C1, the ground selection line GSLa_C1, and the first bit line BL1_C1 of the first cell layer CL1 may be set to a ground GND. Also, each of the string selection line SSLa_C2, the ground selection line GSLa_C2, and the first bit line BL1_C2 of the second cell layer CL2 may be set to the ground GND. In addition, all the word lines of the first cell layer CL1 and the second cell layer CL2 may be set to the ground GND.

At a first time point t1, both the string selection line SSLa_C1 of the first cell layer CL1 and the string selection line SSLa_C2 of the second cell layer CL2 may transition to a string selection voltage VSSL. In this case, the first string STR1_C1 (refer to FIG. 4) of the first cell layer CL1 and the first string STR1_C2 (refer to FIG. 4) of the second cell layer CL2 may be selected. Also, at the first time point t1, all the word lines of the first cell layer CL1 and the second cell layer CL2 may transition to a first pass voltage VPASS1.

At a second time point t2, the first bit line BL1_C1 of the first cell layer CL1 may transition to a first bit line voltage VBL1.

At a third time point t3, selected word lines among the word lines of the first cell layer CL1 and the second cell layer CL2 may transition to a pre-program voltage VPPGM. In this case, referring to FIG. 11, a gate-source voltage VGS2 of memory cells corresponding to selected word lines WL1_C2 to WL3_C2 from among the memory cells of the second cell layer CL2 may correspond to the pre-program voltage VPPGM. In contrast, a gate-source voltage VGS1 of memory cells corresponding to selected word lines WL1_C1 to WL3_C1 from among the memory cells of the first cell layer CL1 may correspond to a voltage level obtained by subtracting the pre-program voltage VPPGM from the first bit line voltage VBL1.

Accordingly, in the pre-program operation, the memory cells of the second cell layer CL2 whose cell characteristic is bad may be pre-programmed to be relatively fast, and the memory cells of the first cell layer CL1 whose cell characteristic is good may be pre-programmed to be relatively slow.

As a result, the cell characteristic difference of the first cell layer CL1 and the second cell layer CL2 may be compensated for by applying bit line voltages of different levels to the first cell layer CL1 and the second cell layer CL2.

Continuing to refer to FIG. 10, at a fourth time point t4, the string selection lines SSLa_C1 and SSLa_C2 and the word lines of the first cell layer CL1 and the second cell layer CL2 and the first bit line BL1_C1 of the first cell layer CL1 may transition to the ground GND, and thus, the pre-program operation may be terminated.

In FIG. 10, the description is given as the characteristic difference is compensated for by differently setting bit line voltage levels of the first cell layer CL1 and the second cell layer CL2. However, this is provided as an example, and embodiments are not limited thereto. According to an embodiment, a layer-specific characteristic difference may be compensated for by differently setting application times of the bit line voltage levels in addition to the bit line voltage levels of the first cell layer CL1 and the second cell layer CL2. For example, during the pre-program operation, the bit line voltage may be applied to the first cell layer CL1 whose cell characteristic is good during a relatively long time, and the bit line voltage may be applied to the second cell layer CL2 whose cell characteristic is bad during a relatively short time.

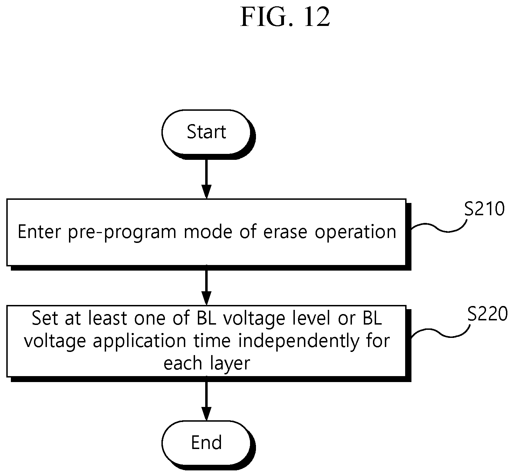

FIG. 12 is a flowchart for describing a pre-program operation performed in an erase operation of a memory device according to an embodiment.

In operation S210, the memory device may enter a pre-program mode in the erase operation.

In operation S220, the memory device may independently set at least one of a bit line voltage to be provided to each layer or an application time of the bit line voltage, based on a layer-specific memory cell characteristic difference, a layer-specific word line loading difference, and/or a layer-specific bit line loading difference.

For example, a characteristic of a first layer may be relatively good compared to a second layer. In this case, a relatively large bit line voltage may be provided to a bit line corresponding to the first layer through a first page buffer, and a relatively small bit line voltage may be provided to a bit line corresponding to the second layer through a second page buffer. Accordingly, in the pre-program operation, a layer-specific characteristic difference may be compensated for.

### [Layer-Specific Control of Verify Operation Condition in Erase Operation]

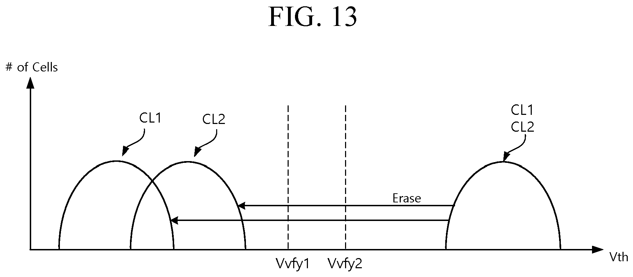

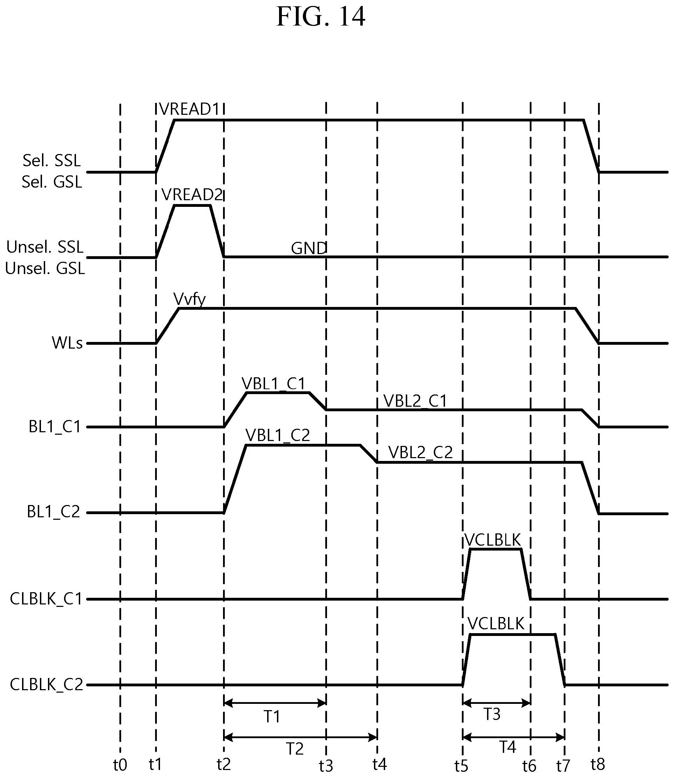

FIGS. 13 and 14 are diagrams for describing a verify operation condition that is differently set for each layer in an erase operation (e.g. in an erase verify operation mode of control logic 1170) according to an embodiment. In detail, FIG. 13 is a diagram for describing an issue of the verify operation due to a cell characteristic difference of the first cell layer CL1 and the second cell layer CL2. FIG. 14 shows an example of a timing diagram in which the hard core operation condition is applied to the first cell layer CL1 and the soft core operation condition is applied to the second cell layer CL2, in the erase verify operation.

Referring to FIG. 13 erase operation characteristics of the first cell layer CL1 and the second cell layer CL2 formed on different wafers may be different. For example, as illustrated in FIG. 13, in the erase operation, a change width of threshold voltages of memory cells of the first cell layer CL1 may be greater than a change width of threshold voltages of memory cells of the second cell layer CL2.

In this case, to verify the erase operation, different verify voltages Vvfy1 and Vvfy2 should be applied to the memory cells of the first cell layer CL1 and the memory cells of the second cell layer CL2. Thus, the verify operation should be performed two times, which causes the degradation of performance of the memory device.

To compensate for the layer-specific characteristic difference, according to an embodiment, in the erase verify operation mode, the first page buffer PB1 (refer to FIG. 4) corresponding to the first cell layer CL1 may be controlled by using the hard core operation condition, and the second page buffer PB2 (refer to FIG. 4) corresponding to the second cell layer CL2 may be controlled by using the soft core operation condition. Accordingly, the verify operation may be performed simultaneously on the first cell layer CL1 and the second cell layer CL2 using the same verify voltage.

In an embodiment, the description will be given in detail with reference to FIGS. 7A, 7B, and 14, at a 0-th time point t0, all of the string selection lines, the ground selection lines, and the bit lines of the first cell layer CL1 and the second cell layer CL2 may be set to the ground GND. Also, both the first bit line connection control signal CLBLK_C1 to be provided to the first page buffer PB1 and the second bit line connection control signal CLBLK_C2 to be provided to the second page buffer PB2 may be set to the ground GND.

At a first time point t1, a selected string selection line among the string selection lines of the first cell layer CL1 and the second cell layer CL2 may transition to a first read voltage VREAD1, and an unselected string selection line among the string selection lines of the first cell layer CL1 and the second cell layer CL2 may transition to a second read voltage VREAD2. A selected ground selection line among the ground selection lines of the first cell layer CL1 and the second cell layer CL2 may transition to the first read voltage VREAD1, and an unselected ground selection line among the ground selection lines of the first cell layer CL1 and the second cell layer CL2 may transition to the second read voltage VREAD2.

The word lines of the first cell layer CL1 and the second cell layer CL2 may transition to a verify voltage Vvfy.

At a second time point t2, the unselected string selection line among the string selection lines of the first cell layer CL1 and of the second cell layer CL2 may transition to the ground GND. The unselected ground selection line among the ground selection lines of the first cell layer CL1 and the second cell layer CL2 may transition to the ground GND.

Also, at the second time point t2, the first bit line BL1_C1 of the first cell layer CL1 may transition to a first bit line voltage VBL1_C1, and the first bit line BL1_C2 of the second cell layer CL2 may transition to a second bit line voltage VBL1_C2. That is, the first bit line BL1_C1 of the first cell layer CL1 may be pre-charged with the first bit line voltage VBL1_C1, and the first bit line BL1_C2 of the second cell layer CL2 may be pre-charged with the second bit line voltage VBL1_C2.

In this case, the bit line voltage VBL1_C1 which is provided to the first cell layer CL1 whose layer characteristic is good may be lower than the bit line voltage VBL1_C2 which is provided to the second cell layer CL2 whose layer characteristic is bad. That is, the hard verify operation condition may be applied to the first cell layer CL1, and the soft verify operation condition may be applied to the second cell layer CL2.

Accordingly, in the erase verify operation, a relatively small amount of current may be generated in the string of the first cell layer CL1 whose layer characteristic is good, and a relatively large amount of current may be generated in the string of the second cell layer CL2 whose layer characteristic is bad. According to the above description, the verify operation on the first cell layer CL1 whose characteristic is good and the verify operation on the second cell layer CL2 whose characteristic is bad may be performed simultaneously by using the same verify operation.

Continuing to refer to FIG. 14, at a third time point t3, the first bit line BL1_C1 of the first cell layer CL1 may transition to a bit line voltage VBL2_C1, and at a fourth time point t4, the first bit line BL1_C2 of the second cell layer CL2 may transition to a bit line voltage VBL2_C2.

In this case, the application time of the bit line voltage VBL1_C1 which is provided to the first cell layer CL1 whose layer characteristic is good may be shorter than the application time of the bit line voltage VBL1_C2 which is provided to the second cell layer CL2 whose layer characteristic is bad. That is, the hard verify operation condition may be applied to the first cell layer CL1, and the soft verify operation condition may be applied to the second cell layer CL2.

Accordingly, in the erase verify operation, a relatively small amount of current may be generated in the string of the first cell layer CL1 whose characteristic is good, and a relatively large amount of current may be generated in the string of the second cell layer CL2 whose characteristic is bad. According to the above description, the verify operation on the first cell layer CL1 whose characteristic is good and the verify operation on the second cell layer CL2 whose characteristic is bad may be performed simultaneously by using the same verify operation.

At a fifth time point t5, each of the first bit line connection control signal CLBLK_C1 provided to the first page buffer PB1 of the first cell layer CL1 and the second bit line connection control signal CLBLK_C2 provided to the second page buffer PB2 of the second cell layer CL2 may be activated, and thus, the sensing operation may be initiated.

At a sixth time point t6, the first bit line connection control signal CLBLK_C1 provided to the first page buffer PB1 of the first cell layer CL1 may be deactivated, and thus, the sensing operation may be terminated. At a seventh time point t7, the second bit line connection control signal CLBLK_C2 provided to the second page buffer PB2 of the second cell layer CL2 may be deactivated, and thus, the sensing operation may be terminated.

In this case, a sensing time T3 corresponding to the first cell layer CL1 whose layer characteristic is good may be shorter than a sensing time T4 corresponding to the second cell layer CL2 whose layer characteristic is bad. That is, the hard verify operation condition may be applied to the first cell layer CL1, and the soft verify operation condition may be applied to the second cell layer CL2. According to the above description, the verify operation on the first cell layer CL1 whose characteristic is good and the verify operation on the second cell layer CL2 whose characteristic is bad may be performed simultaneously by using the same verify operation.

At an eighth time point t8, the string selection lines, the ground selection lines, the word lines, and the bit lines of the first cell layer CL1 and the second cell layer CL2 may transition to the ground GND, and the verify operation associated with the erase operation may be terminated.

For convenience, in FIG. 14, the description is given as all of the method of differently setting a voltage level of a bit line voltage for each layer, the method of differently setting an application time of a bit line voltage for each layer, and the method of differently setting a sensing time for each layer are applied. However, this is provided as an example. According to an embodiment, at least one of the above methods may be applied.

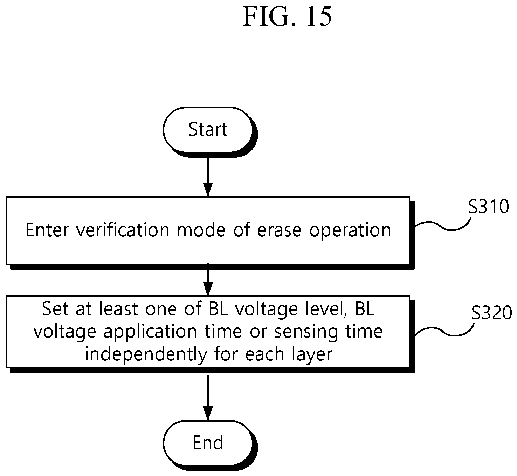

FIG. 15 is a flowchart for describing a verify operation performed in an erase operation of a memory device according to an embodiment.

In operation S310, the memory device may enter a verification mode during the erase operation.

In operation S320, the memory device may independently set at least one of a bit line voltage to a bit line corresponding to each layer, an application time of the bit line voltage, or a sensing time, based on a layer-specific cell characteristic difference, a layer-specific word line loading difference, and/or a layer-specific bit line loading difference.

For example, a characteristic of memory cells of a first layer may be relatively good compared to a second layer. In this case, a bit line corresponding to the first layer may be pre-charged with a relatively low voltage compared to a bit line corresponding to the second layer. Alternatively, the bit line corresponding to the first layer may be pre-charged during a relatively short time compared to the bit line corresponding to the second layer. Alternatively, the sensing time corresponding to the first layer may be relatively short compared to the sensing time corresponding to the second layer. Accordingly, in the verify operation associated with the erase operation, a cell characteristic difference may be compensated for.

### [Layer-Specific Control of Operation Condition of Program]

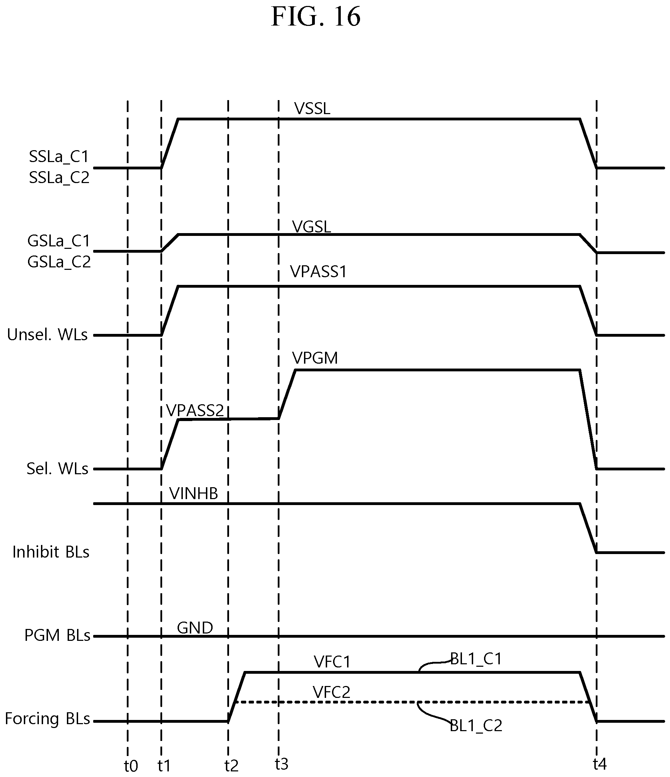

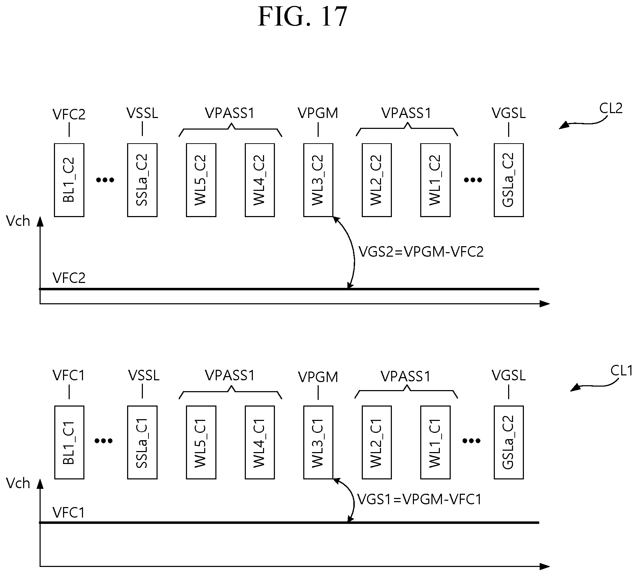

FIGS. 16 and 17 are diagrams for describing a program operation condition that is differently set for each layer (e.g. in a program operation mode of control logic 1170) according to an embodiment. In detail, FIG. 16 shows an example of a timing diagram in which the hard core operation condition is applied to the first cell layer CL1 whose cell characteristic is good and the soft core operation condition is applied to the second cell layer CL2 whose cell characteristic is bad, in the program operation. FIG. 17 is a diagram illustrating an example of the channel voltage Vch when the hard core operation condition is applied to the first cell layer CL1 and the soft core operation condition is applied to the second cell layer CL2.

The program operation to be described with reference to FIGS. 16 and 17 is similar to the pre-program operation described with reference to FIGS. 9 to 11, and thus, repeated description will be omitted to avoid redundancy. For convenience of description, below, it is assumed that a bit line forcing voltage is provided to both the first bit line BL1_C1 of the first cell layer CL1 and the first bit line BL1_C2 of the second cell layer CL2.

Referring to FIG. 16, at a 0-th time point t0, each of the string selection line SSLa_C1, the ground selection line GSLa_C1, and the first bit line BL1_C1 of the first cell layer CL1 may be set to the ground GND. Also, each of the string selection line SSLa_C2, the ground selection line GSLa_C2, and the first bit line BL1_C2 of the second cell layer CL2 may be set to the ground GND. In addition, all the word lines of the first cell layer CL1 and the second cell layer CL2 may be set to the ground GND. Also, a program inhibit voltage VINHB may be provided to a bit line corresponding to a program-inhibited string, and a bit line corresponding to a program-requested string may be set to the ground GND.

At a first time point t1, both the string selection line SSLa_C1 of the first cell layer CL1 and the string selection line SSLa_C2 of the second cell layer CL2 may transition to the string selection voltage VSSL. In this case, the first string STR1_C1 (refer to FIG. 4) of the first cell layer CL1 and the first string STR1_C2 (refer to FIG. 4) of the second cell layer CL2 may be selected. Also, at the first time point t1, unselected word lines among the word lines of the first cell layer CL1 and the second cell layer CL2 may transition to the first pass voltage VPASS1, and selected word lines thereof may transition to a second pass voltage VPASS2.

At a second time point t2, the first bit line BL1_C1 of the first cell layer CL1 may transition to a first bit line forcing voltage VFC1, and the first bit line BL1_C2 of the second cell layer CL2 may transition to a second bit line forcing voltage VFC2.

In this case, the first bit line forcing voltage VFC1 which is provided to the first cell layer CL1 whose layer characteristic is good may be relatively high compared to the second bit line forcing voltage VFC2 which is provided to the second cell layer CL2 whose layer characteristic is bad. That is, the hard program operation condition may be applied to the first cell layer CL1, and the soft program operation condition may be applied to the second cell layer CL2.

At a third time point t3, the selected word lines may transition to a program voltage VPGM.

In this case, referring to FIG. 17, because the second bit line forcing voltage VFC2 is provided to the first bit line BL1_C2 of the second cell layer CL2, the gate-source voltage VGS2 of a memory cell corresponding to the selected word line WL3_C2 may correspond to a voltage level obtained by subtracting the second bit line forcing voltage VFC2 from the program voltage VPGM. Because the first bit line forcing voltage VFC1 is provided to the first bit line BL1_C1 of the first cell layer CL1, the gate-source voltage VGS1 of a memory cell corresponding to the selected word line WL3_C1 may correspond to a voltage level obtained by subtracting the first bit line forcing voltage VFC1 from the program voltage VPGM.

In this case, because the first bit line forcing voltage VFC1 is greater than the second bit line forcing voltage VFC2, a program voltage of a relatively low level may be provided to the selected memory cell of the first cell layer CL1 whose characteristic is good, and a program voltage of a relatively high level may be provided to the selected memory cell of the second cell layer CL2 whose characteristic is bad.

According to the above description, the characteristic difference of the first cell layer CL1 and the second cell layer CL2 may be compensated for by applying bit line forcing voltages of different levels to the first cell layer CL1 and the second cell layer CL2.

At a fourth time point t4, the string selection lines SSLa_C1 and SSLa_C2 and the word lines of the first cell layer CL1 and the second cell layer CL2 and the first bit line BL1_C1 of the first cell layer CL1 may transition to the ground GND, and thus, the program operation may be terminated.

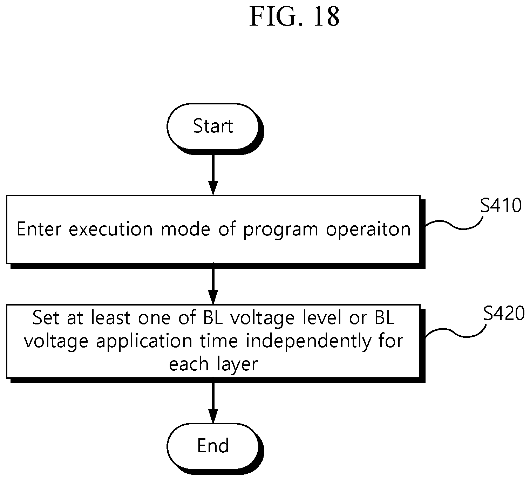

FIG. 18 is a flowchart for describing a program operation of a memory device according to an embodiment.

In operation S410, the memory device may enter an execution mode in the program operation.

In operation S420, the memory device may independently set at least one of a bit line forcing voltage to be provided to each layer or an application time of the bit line forcing voltage, based on a layer-specific cell characteristic difference, a layer-specific word line loading difference, and/or a layer-specific bit line loading difference.

For example, a characteristic of memory cells of a first layer may be relatively good compared to a second layer. In this case, a relatively large bit line forcing voltage may be provided to a bit line corresponding to the first layer through a first page buffer, and a relatively small bit line forcing voltage may be provided to a bit line corresponding to the second layer through a second page buffer. Alternatively, a bit line forcing voltage may be provided to the bit line corresponding to the first layer through the first page buffer during a relatively long time, and a bit line forcing voltage may be provided to the bit line corresponding to the second layer through the second page buffer during a relatively short time. Accordingly, in the program operation, a cell characteristic difference may be compensated for.

### [Layer-Specific Control of Verify Operation Condition in Program Verify Operation]

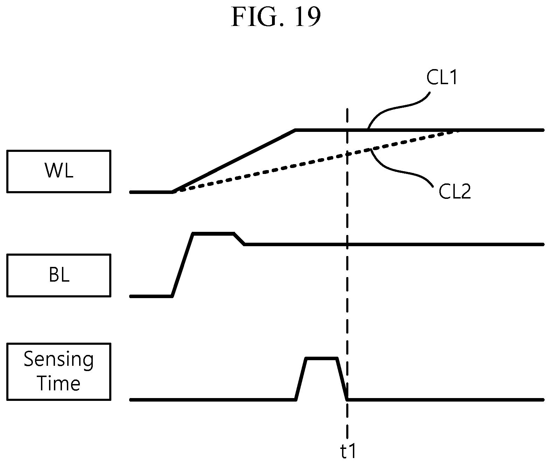

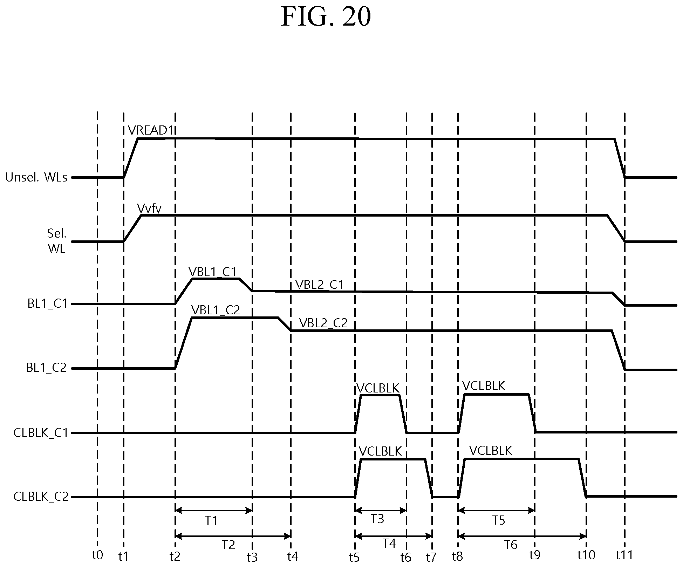

FIGS. 19 and 20 are diagrams for describing a verify operation condition that is differently set for each layer in a program verify operation (e.g. in a program verify operation mode of control logic 1170) according to an embodiment. In detail, FIG. 19 is a diagram for describing an issue of the program verify operation due to a word line loading difference of the first cell layer CL1 and the second cell layer CL2. FIG. 20 shows an example of a timing diagram in which the hard core operation condition is applied to the first cell layer CL1 and the soft core operation condition is applied to the second cell layer CL2, in the program verify operation.

The program verify operation to be described with reference to FIGS. 19 and 20 is similar to the erase verify operation described with reference to FIGS. 13 and 14, and thus, repeated description will be omitted to avoid redundancy.

Referring to FIGS. 4 and 19, the first cell layer CL1 may be stacked on the peri layer PL, and the second cell layer CL2 may be stacked on the first cell layer CL1. Accordingly, a length of a word line corresponding to the first cell layer CL1 may be shorter than a length of a word line corresponding to the second cell layer CL2. In this regard, a word line loading time corresponding to the first cell layer CL1 may be short compared to a word line loading time corresponding to the second cell layer CL2.

In this case, as illustrated in FIG. 19, at a first time point t1 at which the sensing operation is terminated, the loading of the word line of the first cell layer CL1 whose word line loading characteristic is good may be completed, but the loading of the word line of the second cell layer CL2 whose word line loading characteristic is bad may not be completed. This causes the reduction of reliability of the memory device.

To compensate for the layer-specific word line loading characteristic difference, according to an embodiment, in the program verify operation, the first page buffer PB1 (refer to FIG. 1) corresponding to the first cell layer CL1 may be controlled by using the hard core operation condition, and the second page buffer PB2 (refer to FIG. 4) corresponding to the second cell layer CL2 may be controlled by using the soft core operation condition. Accordingly, the reliability of the program verify operation may be improved.

In an embodiment, the description will be given in detail with reference to FIGS. 7A, 7B, and 20. At a 0-th time point t0, all of the word lines and the bit lines of the first cell layer CL1 and the second cell layer CL2 may be set to the ground GND. Also, both the first bit line connection control signal CLBLK_C1 to be provided to the first page buffer PB1 and the second bit line connection control signal CLBLK_C2 to be provided to the second page buffer PB2 may be set to the ground GND.

At a first time point t1, unselected word lines among the word lines of the first cell layer CL1 and the second cell layer CL2 may transition to the first read voltage VREAD1, and selected word lines among the word lines of the first cell layer CL1 and the second cell layer CL2 may transition to the verify voltage Vvfy.

At a second time point t2, the first bit line BL1_C1 of the first cell layer CL1 may transition to the first bit line voltage VBL1_C1, and the first bit line BL1_C2 of the second cell layer CL2 may transition to the bit line voltage VBL1_C2. That is, the first bit line BL1_C1 of the first cell layer CL1 may be pre-charged with the first bit line voltage VBL1_C1, and the first bit line BL1_C2 of the second cell layer CL2 may be pre-charged with the second bit line voltage VBL1_C2.

In this case, the bit line voltage VBL1_C1 which is provided to the first cell layer CL1 whose word line loading characteristic is good may be lower than the bit line voltage VBL1_C2 which is provided to the second cell layer CL2 whose word line loading characteristic is bad. That is, the hard program verify operation condition may be applied to the first cell layer CL1, and the soft program verify operation condition may be applied to the second cell layer CL2. Accordingly, the reliability of the program verify operation may be improved.

Continuing to refer to FIG. 20, at a third time point t3, the first bit line BL1_C1 of the first cell layer CL1 may transition to the bit line voltage VBL2_C1, and the first bit line BL1_C2 of the second cell layer CL2 may transition to the bit line voltage VBL2_C2.

In this case, an application time T1 of the bit line voltage VBL1_C1 which is provided to the first cell layer CL1 whose word line loading characteristic is good may be short compared to an application time T2 of the bit line voltage VBL1_C2 which is provided to the second cell layer CL2 whose word line loading characteristic is bad. That is, the hard program verify operation condition may be applied to the first cell layer CL1, and the soft program verify operation condition may be applied to the second cell layer CL2. Accordingly, the reliability of the program verify operation may be improved.

At a fifth time point t5, each of the first bit line connection control signal CLBLK_C1 provided to the first page buffer PB1 of the first cell layer CL1 and the second bit line connection control signal CLBLK_C2 provided to the second page buffer PB2 of the second cell layer CL2 may be activated, and thus, a coarse sensing operation may be initiated.

At a sixth time point t6, the first bit line connection control signal CLBLK_C1 provided to the first page buffer PB1 of the first cell layer CL1 may be deactivated, and thus, the coarse sensing operation on the first bit line BL1_C1 may be terminated. At a seventh time point t7, the second bit line connection control signal CLBLK_C2 provided to the second page buffer PB2 of the second cell layer CL2 may be deactivated, and thus, the coarse sensing operation may be terminated.

In this case, a coarse sensing time T3 corresponding to the first cell layer CL1 whose word line loading characteristic is good may be shorter than a coarse sensing time T4 corresponding to the second cell layer CL2 whose word line loading is bad. That is, the hard program verify operation condition may be applied to the first cell layer CL1, and the soft program verify operation condition may be applied to the second cell layer CL2. Accordingly, the reliability of the coarse program sensing operation may be improved.

At an eighth time point t8, each of the first bit line connection control signal CLBLK_C1 provided to the first page buffer PB1 of the first cell layer CL1 and the second bit line connection control signal CLBLK_C2 provided to the second page buffer PB2 of the second cell layer CL2 may be activated, and thus, a fine sensing operation may be initiated.

At a ninth time point t9, the first bit line connection control signal CLBLK_C1 provided to the first page buffer PB1 of the first cell layer CL1 may be deactivated, and thus, the fine sensing operation on the first bit line BL1_C1 may be terminated. At a tenth time point t10, the second bit line connection control signal CLBLK_C2 provided to the second page buffer PB2 of the second cell layer CL2 may be deactivated, and thus, the fine sensing operation for the first bit line BL1_C2 may be terminated.

In this case, a fine sensing time T5 corresponding to the first cell layer CL1 whose word line loading characteristic is good may be shorter than a fine sensing time T6 corresponding to the second cell layer CL2 whose word line loading is bad. That is, the hard program verify operation condition may be applied to the first cell layer CL1, and the soft program verify operation condition may be applied to the second cell layer CL2. Accordingly, the reliability of the fine program sensing operation may be improved.

At an eleventh time point t11, the string selection lines, the ground selection lines, the word lines, and the bit lines of the first cell layer CL1 and the second cell layer CL2 may transition to the ground GND, and the program verify operation may be terminated.

For convenience, in FIG. 20, the description is given as all of the method of differently setting a voltage level of a bit line voltage for each layer, the method of differently setting an application time of a bit line voltage for each layer, and the method of differently setting a coarse sensing time and a fine sensing time for each layer are applied. However, this is provided as an example. According to an embodiment, at least one of the above methods may be applied.

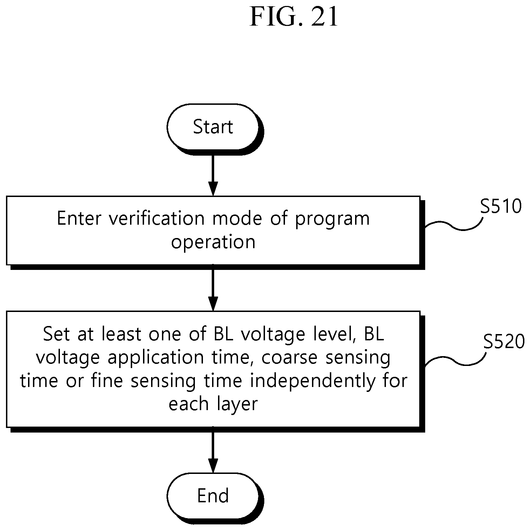

FIG. 21 is a flowchart for describing a program verify operation of a memory device according to an embodiment.

In operation S510, the memory device may enter a program verification mode during the program operation.

In operation S520, the memory device may independently set at least one of a bit line voltage corresponding to each layer, an application time of the bit line voltage, a coarse sensing time, or a fine sensing time, based on a layer-specific cell characteristic difference, a layer-specific word line loading difference, and/or a layer-specific bit line loading difference.

Accordingly, in the program verify operation, a layer-specific word line loading characteristic difference may be compensated for.

### [Layer-Specific Control of Read Operation Condition]

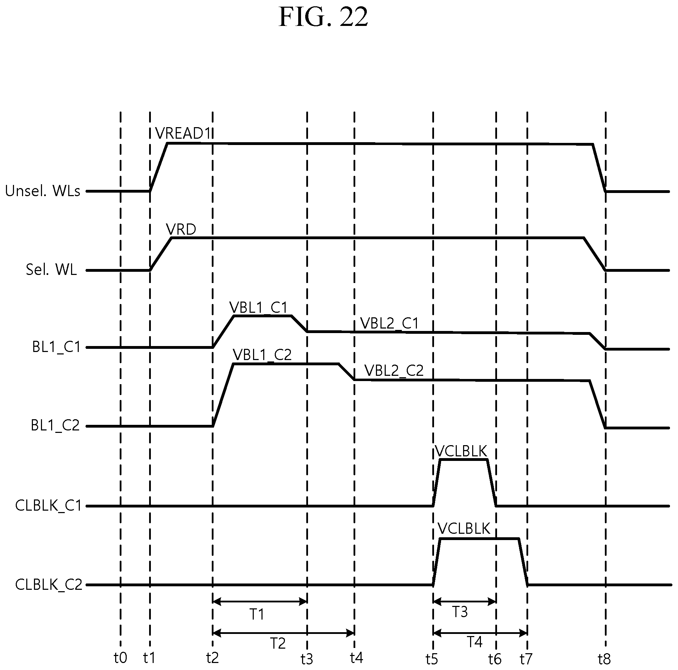

FIG. 22 shows a timing diagram in which the hard core operation condition is applied to the first cell layer CL1 and the soft core operation condition is applied to the second cell layer CL2, in the read operation (e.g. in a read operation mode of control logic 1170) according to an embodiment.

The read operation to be described with reference to FIG. 22 is similar to the program verify operation described with reference to FIGS. 19 and 20, and thus, repeated description will be omitted to avoid redundancy.

As described above, the reliability of the read operation may be reduced due to a layer-specific word line loading characteristic difference. To compensate for the layer-specific word line loading characteristic difference, according to an embodiment, in the read operation, the first page buffer PB1 (refer to FIG. 1) corresponding to the first cell layer CL1 may be controlled by using the hard core operation condition, and the second page buffer PB2 (refer to FIG. 4) corresponding to the second cell layer CL2 may be controlled by using the soft core operation condition. Accordingly, the reliability of the read operation may be improved.

In an embodiment, the description will be given in detail with reference to FIGS. 7A, 7B, and 22. At a 0-th time point t0, all of the word lines and the bit lines of the first cell layer CL1 and the second cell layer CL2 may be set to the ground GND. Also, both the first bit line connection control signal CLBLK_C1 to be provided to the first page buffer PB1 and the second bit line connection control signal CLBLK_C2 to be provided to the second page buffer PB2 may be set to the ground GND.

At a first time point t1, unselected word lines among the word lines of the first cell layer CL1 and the second cell layer CL2 may transition to the first read voltage VREAD1, and selected word lines among the word lines of the first cell layer CL1 and the second cell layer CL2 may transition to the read voltage VRD.

At a second time point t2, the first bit line BL1_C1 of the first cell layer CL1 may transition to the first bit line voltage VBL1_C1, and the first bit line BL1_C2 of the second cell layer CL2 may transition to the bit line voltage VBL1_C2. That is, the first bit line BL1_C1 of the first cell layer CL1 may be pre-charged with the first bit line voltage VBL1_C1, and the first bit line BL1_C2 of the second cell layer CL2 may be pre-charged with the second bit line voltage VBL1_C2.

In this case, the bit line voltage VBL1_C1 which is provided to the first cell layer CL1 whose word line loading characteristic is good may be lower than the bit line voltage VBL1_C2 which is provided to the second cell layer CL2 whose word line loading characteristic is bad. Accordingly, the reliability of the program verify operation may be improved.

Continuing to refer to FIG. 22, at a third time point t3, the first bit line BL1_C1 of the first cell layer CL1 may transition to a bit line voltage VBL2_C1, and at a fourth time point t4, the first bit line BL1_C2 of the second cell layer CL2 may transition to a bit line voltage VBL2_C2.

In this case, an application time T1 of the bit line voltage VBL1_C1 which is provided to the first cell layer CL1 whose word line loading characteristic is good may be short compared to an application time T2 of the bit line voltage VBL1_C2 which is provided to the second cell layer CL2 whose word line loading characteristic is bad. Accordingly, the reliability of the program verify operation may be improved.

At a fifth time point t5, each of the first bit line connection control signal CLBLK_C1 provided to the first page buffer PB1 of the first cell layer CL1 and the second bit line connection control signal CLBLK_C2 provided to the second page buffer PB2 of the second cell layer CL2 may be activated, and thus, the sensing operation may be initiated.

At a sixth time point t6, the first bit line connection control signal CLBLK_C1 provided to the first page buffer PB1 of the first cell layer CL1 may be deactivated, and thus, the sensing operation on the first bit line BL1_C1 may be terminated. At a seventh time point t7, the second bit line connection control signal CLBLK_C2 provided to the second page buffer PB2 of the second cell layer CL2 may be deactivated, and thus, the sensing operation may be terminated.

In this case, the sensing time T3 corresponding to the first cell layer CL1 whose word line loading characteristic is good may be shorter than the sensing time T4 corresponding to the second cell layer CL2 whose word line loading is bad. Accordingly, the reliability of the coarse program sensing operation may be improved.

At an eighth time point t8, the string selection lines, the ground selection lines, the word lines, and the bit lines of the first cell layer CL1 and the second cell layer CL2 may transition to the ground GND, and the program verify operation may be terminated.

For convenience, in FIG. 22, the description is given as all of the method of differently setting a voltage level of a precharged bit line voltage for each layer, the method of differently setting an application time of a precharged bit line voltage for each layer, and the method of differently setting a sensing time for each layer are applied. However, this is provided as an example. According to an embodiment, at least one of the above methods may be applied.

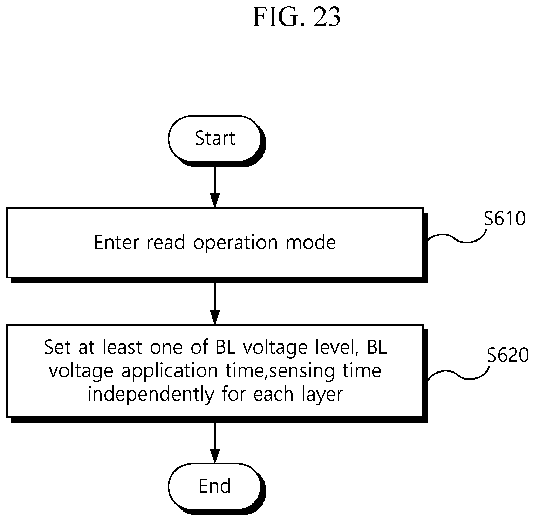

FIG. 23 is a flowchart for describing a read operation of a memory device according to an embodiment.

In operation S610, the memory device may enter a read operation mode.

In operation S620, the memory device may independently set at least one of a bit line voltage corresponding to each layer, an application time of the bit line voltage, or a sensing time, based on a layer-specific cell characteristic difference, a layer-specific word line loading difference, and/or a layer-specific bit line loading difference.

Accordingly, in a read operation, a layer-specific word line loading characteristic difference may be compensated for.

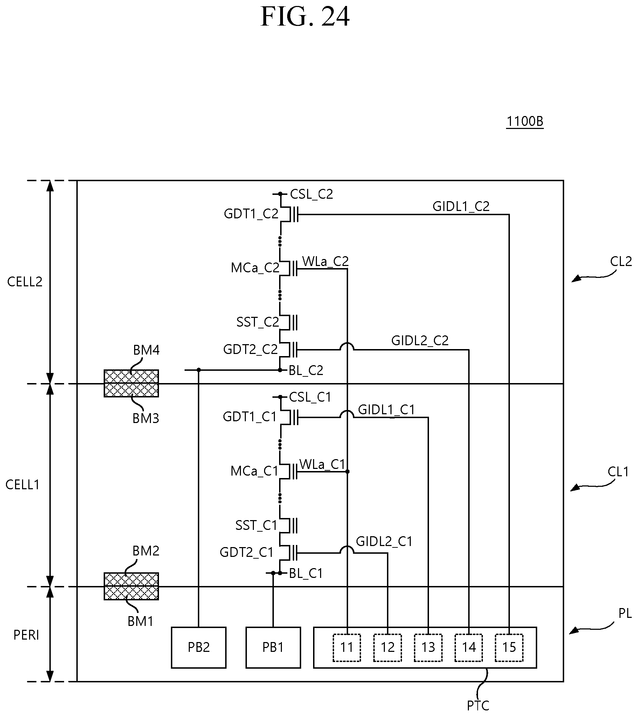

In FIGS. 4 to 23, various embodiments in which a characteristic difference of layers is compensated for by controlling a page buffer independently for each layer. However, this is provided as an example, and embodiments are not limited thereto. For example, in an embodiment, a characteristic difference of layers may be compensated for by controlling a word line except for a main word line independently for each layer. This will be described in detail with reference to FIGS. 24 to FIG. 27 below.

### [Word Line Except for Main Word Line Controlled Independently for Each Layer]

FIG. 24 is a cross-sectional view for conceptually describing implementation of a memory device of FIG. 2 according to an embodiment. As in the above description given with reference to 4, it is assumed that a memory device 1100B of FIG. 24 is implemented by bonding three chips, a memory cell array is implemented with two chips, the bit line BL_C1 of the first cell layer CL1 is connected to the first page buffer PB1, and the bit line BL_C2 of the second cell layer CL2 is connected to the second page buffer PB2.

A configuration of the memory device 1100B of FIG. 24 is similar to the configuration of the memory device 1100A of FIG. 4, and thus, repeated description will be omitted to avoid redundancy.

Referring to FIG. 24, when viewed in the vertical direction, the memory device 1100B may include the peri layer PL, the first cell layer CL1, and the second cell layer CL2.

The pass transistor circuit PTC may be formed in the peri layer PL. The pass transistor circuit PTC may include first to fifth pass transistors 11 to 15.

The first pass transistor 11 may be connected in common to the word line WLa_C1 of the first cell layer CL1 and the word line WLa_C2 of the second cell layer CL2. Accordingly, in the core operation, the word line WLa_C1 of the first cell layer CL1 and the word line WLa_C2 of the second cell layer CL2 may be simultaneously driven.

The second pass transistor 12 may be electrically connected to the second GIDL line GIDL2_C1 of the first cell layer CL1.

The third pass transistor 13 may be electrically connected to the first GIDL line GIDL1_C1 of the first cell layer CL1.

The fourth pass transistor 14 may be electrically connected to the second GIDL line GIDL2_C2 of the second cell layer CL2.

The fifth pass transistor 15 may be electrically connected to the first GIDL line GIDL1_C2 of the second cell layer CL2.

In the core operation, the control of the first and second GIDL lines GIDL1_C1 and GIDL2_C1 of the first cell layer CL1 and the control of the first and second GIDL lines GIDL1_C2 and GIDL2_C2 of the second cell layer CL2 may be performed independently of each other. Accordingly, for example, in the GIDL erase operation, the floating time of the GIDL line may be variable, and thus, a layer-specific characteristic difference may be compensated for.

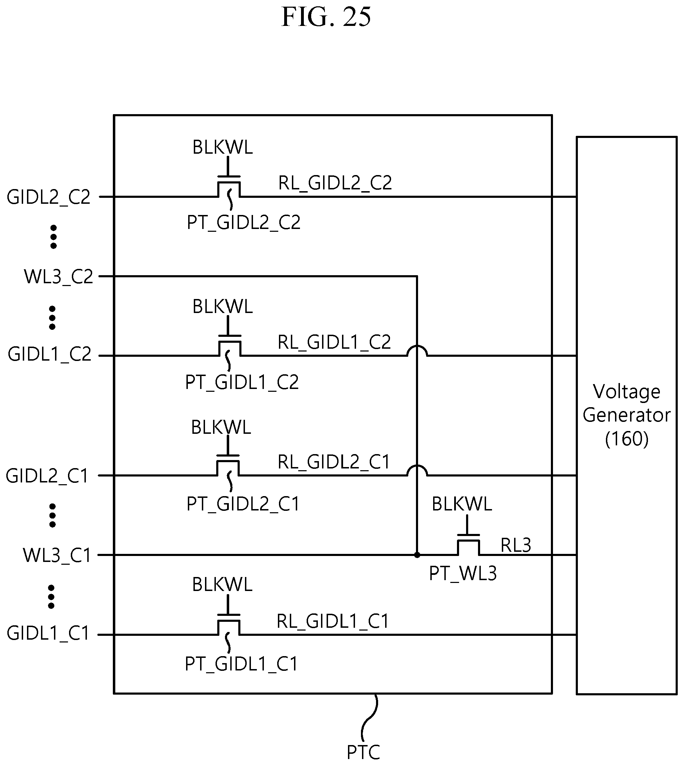

FIG. 25 is a diagram for describing the pass transistor circuit PTC of FIG. 24 according to an embodiment. For convenience of description, pass transistors connected to the first and second GIDL lines GIDL1_C1 and GIDL2_C1 of the first cell layer CL1 and the first and second GIDL lines GIDL1_C2 and GIDL2_C2 of the second cell layer CL2 and a pass transistor connected in common to the third word line WL3_C1 of the first cell layer CL1 and the third word line WL3_C2 of the second cell layer CL2 are illustrated in FIG. 25 as an example.

Referring to FIG. 25, the pass transistor circuit PTC may include a plurality of pass transistors PT_WL3, PT_GIDL1_C1, PT_GIDL2_C1, PT_GIDL1_C2, and PT_GIDL2_C2. Gates of the plurality of pass transistors PT_WL3, PT_GIDL1_C1, PTGIDL2_C1, PT_GIDL1_C2, and PT_GIDL2_C2 may be connected to the block word line BLKWL.

A first end of the pass transistor PT_WL3 may be connected to the third word line WL3_C1 of the first cell layer CL1 and the third word line WL3_C2 of the second cell layer CL2. A second end of the pass transistor PT_WL3 may be connected to a third row line RL3. In response to the voltage level of the block word line BLKWL, the pass transistor PT_WL3 may provide a voltage received from the voltage generator 160 to each of the third word line WL3_C1 of the first cell layer CL1 and the third word line WL3_C2 of the second cell layer CL2 through the third row line RL3.

A first end of the pass transistor PT_GIDL1_C1 may be connected to the first GIDL line GIDL1_C1 of the first cell layer CL1, and a second end thereof may be connected to a row line RL_GIDL1_C1. The first GIDL line GIDL1_C1 of the first cell layer CL1 may be independently driven by the pass transistor PT_GDIL1_C1.

As in the above description, a first end of the pass transistor PT_GIDL2_C1 may be connected to the second GIDL line GIDL2_C1 of the first cell layer CL1, and a second end thereof may be connected to a row line RL_GIDL2_C1. A first end of the pass transistor PT_GIDL1_C2 may be connected to the first GIDL line GIDL1_C2 of the second cell layer CL2, and a second end thereof may be connected to a row line RL_GIDL1_C2. A first end of the pass transistor PT_GIDL2_C2 may be connected to the second GIDL line GIDL2_C2 of the second cell layer CL2, and a second end thereof may be connected to a row line RL_GIDL2_C2. Each of the pass transistors PT_WL3, PT_GIDL1_C1, PT_GIDL2_C1, PT_GIDL1_C2, and PTGIDL2_C2 may independently drive the corresponding GIDL line.

According to an embodiment, the layer-specific characteristic difference may be compensated for through the layer-specific independent control of the GIDL line.

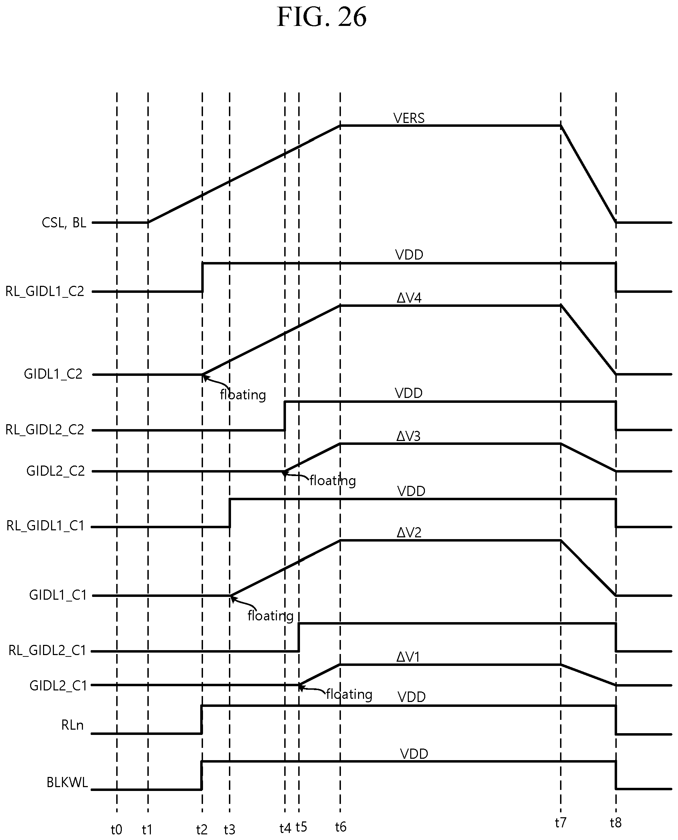

FIG. 26 is a timing diagram illustrating a GIDL erase operation in which a floating time is changed such that a layer-specific characteristic difference is compensated for according to an embodiment. For convenience of description, below, it is assumed that the characteristic of the first cell layer CL1 is bad compared to the second cell layer CL2.

Referring to FIGS. 24 to 26, at a 0-th time point t0, the bit line, the common source line, the GIDL line, the row line, etc., may be set to the ground GND.

At a first time point t1, voltages provided through the common source line CSL and the bit line BL may start to increase. For example, the voltages provided through the common source line CSL and the bit line BL may be voltages which stepwise increase. For example, the voltages provided through the common source line CSL and the bit line BL may be voltages which increase constantly.

At a second time point t2, the block word line BLKWL and the row line RL_GIDL1_C2 may increase to the power supply voltage VDD. Accordingly, the first GIDL line GIDL1_C2 of the second cell layer CL2 may be floated. As the voltage provided through the common source line CSL of the second cell layer CL2 increases to an erase voltage VERS, the voltage of the first GIDL line GIDL1_C2 of the second cell layer CL2 may also increase together. In this case, the voltage of the first GIDL line GIDL1_C2 may increase to a fourth voltage ΔV4. In an embodiment, the fourth voltage ΔV4 may correspond to the increment of the voltage level from the second time point t2 to a sixth time point t6.

At a third time point t3, the row line RL_GIDL1_C1 may increase to the power supply voltage VDD. Accordingly, the first GIDL line GIDL1_C1 of the first cell layer CL1 may be floated. As the voltage provided through the common source line CSL of the first cell layer CL1 increases to the erase voltage VERS, the voltage of the first GIDL line GIDL1_C1 of the first cell layer CL1 may also increase together. In this case, the voltage of the first GIDL line GIDL1_C1 may increase to a second voltage ΔV2. In an embodiment, the second voltage ΔV2 may correspond to the increment of the voltage level from the third time point t3 to the sixth time point t6.

As in the above description, at a fourth time point t4, the row line RL_GIDL2_C2 may increase to the power supply voltage VDD. Accordingly, the second GIDL line GIDL2_C2 of the second cell layer CL2 may be floated. As the voltage provided through the bit line BL of the second cell layer CL2 increases to the erase voltage VERS, the voltage of the second GIDL line GIDL2_C2 of the second cell layer CL2 may also increase together. In this case, the voltage of the first GIDL line GIDL1_C2 may increase to a third voltage ΔV3. In an embodiment, the third voltage ΔV3 may correspond to the increment of the voltage level from the fourth time point t4 to the sixth time point t6.

At a fifth time point t5, the row line RL_GIDL2_C1 may increase to the power supply voltage VDD. Accordingly, the second GIDL line GIDL2_C1 of the first cell layer CL1 may be floated. As the voltage provided through the bit line BL of the first cell layer CL1 increases to the erase voltage VERS, the voltage of the second GIDL line GIDL2_C1 of the first cell layer CL1 may also increase together. In this case, the voltage of the second GIDL line GIDL2_C1 may increase to a first voltage ΔV1. In an embodiment, the first voltage ΔV1 may correspond to the increment of the voltage level from the fifth time point t5 to the sixth time point t6.

At the sixth time point t6, the voltage provided through the common source line CSL or the bit line BL may increase to the voltage level of the erase voltage VERS. Accordingly, the GIDL erase operation may be performed.

In this case, because the floating times of the GIDL lines GIDL1_C1 and GIDL2_C1 of the first cell layer CL1 and the GIDL lines GIDL1_C2 and GIDL2_C2 of the second cell layer CL2 are different from each other, the layer-specific GIDL erase speed difference may be compensated for.

For example, when the first cell layer CL1 has a relatively bad characteristic, as illustrated, the GIDL lines of the first cell layer CL1 may be floated to be relatively slow. For example, when the second cell layer CL2 has a relatively good characteristic, the GIDL lines of the second cell layer CL2 may be floated to be relatively fast.

As described above, as the floating time of the GIDL line is variable for each layer, the layer-specific characteristic difference may be compensated for.

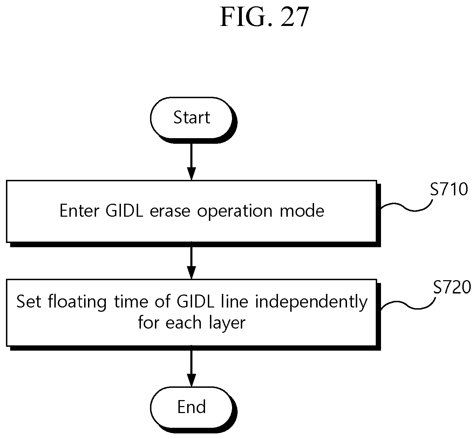

FIG. 27 is a flowchart for describing a read operation of a memory device according to an embodiment.

In operation S710, the memory device may enter a GIDL erase operation mode.

In operation S720, the memory device may independently control a floating time of a GIDL line corresponding to each layer, based on a layer-specific cell characteristic difference, a layer-specific word line loading difference, and/or a layer-specific bit line loading difference.

For example, a GIDL line corresponding to a cell layer whose characteristic is relatively good may be fast floated, and a GIDL line corresponding to a cell layer whose characteristic is relatively bad may be slowly floated. Accordingly, the layer-specific characteristic difference may be compensated for.

A memory device according to the present disclosure may be implemented by a bonding method and may improve the reliability of a core operation.

While aspects of embodiments have been particularly shown and described, it will be understood that various changes in form and details may be made therein without departing from the scope of the following claims.

## Claims

1. A memory device comprising:
a memory cell array (1110) comprising a first string (STR1_C1) provided in a first layer (CL1) and a second string (STR1_C2) provided in a second layer (CL2) stacked on the first layer (CL1);
a page buffer circuit (1140) comprising a first page buffer (PB1) corresponding to the first string (STR1_C1) of the first layer (CL1) and a second page buffer (PB2) corresponding to the second string (STR1_C2) of the second layer (CL2); and
a control logic circuit (1170) configured to control the first page buffer (PB1) and the second page buffer (PB2) independently, in a core operation.

2. The memory device of claim 1, further comprising a first pass transistor (PT_WL1) comprising a first end connected in common to a first word line (WL1_C1) of the first string (STR1_C1) and a second word line (WL1_C2) of the second string (STR1_C2), and a second end connected to a first row line (RL1).

3. The memory device of claim 2, wherein the control logic circuit (1170) is further configured to, in a pre-program operation mode, control a pre-program voltage to be applied to the first word line (WL1_C1) of the first string (STR1_C1) and the second word line (WL1_C2) of the second string (STR1_C2), a first bit line voltage to be applied to a first bit line (BL1_C1) of the first string (STR1_C1), and a second bit line voltage to be applied to a second bit line (BL1_C2) of the second string (STR1_C2), and
wherein a voltage level of the first bit line voltage and a voltage level of the second bit line voltage are different from each other.

4. The memory device of claim 2, wherein the control logic circuit (1170) is further configured to, in an erase verify operation mode, control a verify voltage (Vvfy) to be applied to the first word line (WL1_C1) of the first string (STR1_C1) and the second word line (WL1_C2) of the second string (STR1_C2), a first bit line voltage (VBL1_C1) to be applied to a first bit line (BL1_C1) of the first string (STR1_C1), and a second bit line voltage (VBL1_C2) to be applied to a second bit line (BL1_C2) of the second string (STR1_C2), and
wherein a voltage level of the first bit line voltage (VBL1_C1) and a voltage level of the second bit line voltage (VBL1_C2) are different from each other.

5. The memory device of claim 4, wherein the control logic circuit (1170) is further configured to, in the erase verify operation mode, control the first bit line voltage to be provided during a first time, and the second bit line voltage to be provided during a second time different from the first time.

6. The memory device of claim 4 or 5, wherein the first page buffer (PB1) comprises a first transistor (NM3) configured to selectively connect the first bit line (BL1_C1) of the first string (STR1_C1) and a first sensing node according to a first bit line connection control signal (CLBLK_C1),
wherein the second page buffer (PB2) comprises a second transistor configured to selectively connect the second bit line (BL1_C2) of the second string (STR1_C2) and a second sensing node according to a second bit line connection control signal (CLBLK_C2), and
wherein the control logic circuit (1170) is further configured to, in the erase verify operation mode, control a time (T3) during which the first bit line connection control signal (CLBLK_C1) is activated to be different from a time (T4) during which the second bit line connection control signal (CLBLK_C2) is activated.

7. The memory device of claim 2, wherein the control logic circuit (1170) is further configured to, in a program operation mode, control a program voltage to be applied to the first word line (WL1_C1) of the first string (STR1_C1) and the second word line (WL1_C2) of the second string (STR1_C2), a first bit line forcing voltage (VFC1) to be applied to a first bit line (BL1_C1) of the first string (STR1_C1), and a second bit line forcing voltage (VFC2) to be applied to a second bit line (BL1_C2) of the second string (STR1_C2), and
wherein a voltage level of the first bit line forcing voltage (VFC1) and a voltage level of the second bit line forcing voltage (VFC2) are different from each other.

8. The memory device of claim 2, wherein the control logic circuit (1170) is further configured to, in a program verify operation mode, control a verify voltage (Vvfy) to be applied to the first word line (WL1_C1) of the first string (STR1_C1) and the second word line (WL1_C2) of the second string (STR1_C2), a first bit line voltage (VBL1_C1) to be applied to a first bit line (BL1_C1) of the first string (STR1_C1), and a second bit line voltage (VBL1_C2) to be applied to a second bit line (BL1_C2) of the second string (STR1_C2), and
wherein a voltage level of the first bit line voltage (VBL1_C1) and a voltage level of the second bit line voltage (VBL1_C2) are different from each other.

9. The memory device of claim 8, wherein the control logic circuit (1170) is further configured to, in the program verify operation mode, control the first bit line voltage (VBL1_C1) to be provided during a first time (T1), and the second bit line voltage (VBL1_C2) to be provided during a second time (T2) different from the first time (T1).

10. The memory device of claim 8 or 9, wherein the first page buffer (PB1) comprises a first transistor (NM3) configured to selectively connect the first bit line (BL1_C1) of the first string (STR1_C1) and a first sensing node according to a first bit line connection control signal (CLBLK_C1),
wherein the second page buffer (PB2) comprises a second transistor (NM10) configured to selectively connect the second bit line (BL1_C2) of the second string (STR1_C2) and a second sensing node according to a second bit line connection control signal (CLBLK_C2), and
wherein the control logic circuit (1170) is further configured to, in the program verify operation mode, control a first sensing time (T3, T5) during which the first bit line connection control signal (CLBLK_C1) is activated to be different from a second sensing time (T4, T6) during which the second sensing bit line connection control signal (CLBLK_C2)is activated.

11. The memory device of claim 10, wherein the first sensing time during which the first bit line connection control signal (CLBLK_C1) is activated comprises a first coarse sensing time (T3) and a first fine sensing time (T5),
wherein the second sensing time (T4, T6) during which the second bit line connection control signal (CLBLK_C2) is activated comprises a second coarse sensing time (T4) and a second fine sensing time (T5), and
wherein the first coarse sensing time (T3) and the second coarse sensing time (T4) are different from each other, and the first fine sensing time (T5) and the second fine sensing time (T6) are different from each other.

12. The memory device of claim 2, wherein the control logic circuit (1170) is further configured to, in a read operation mode, control a read voltage (VRD) to be applied to the first word line (WL1_C1) of the first string (STR1_C1) and the second word line (WL1_C2) of the second string (STR1_C2), a first bit line voltage (VBL1_C1) to be applied to a first bit line (BL1_C1) of the first string (STR1_C1), and a second bit line voltage (VBL1_C2) to be applied to a second bit line (BL1_C2) of the second string (STR1_C2), and
wherein a voltage level of the first bit line voltage (VBL1_C1) and a voltage level of the second bit line voltage (VBL1_C2) are different from each other.

13. The memory device of claim 12, wherein the control logic circuit (1170) is further configured to, in the read operation mode, control the first bit line voltage (VBL1_C1) to be provided during a first time (T1), and the second bit line voltage (VBL1_C2) to be provided during a second time (T2) different from the first time (T1).

14. The memory device of claim 13, wherein the first page buffer (PB1) comprises a first transistor (NM3) configured to selectively connect the first bit line (BL1_C1) of the first string (STR1_C1) and a first sensing node according to a first bit line connection control signal (CLBLK_C1),
wherein the second page buffer (PB2) comprises a second transistor (NM10) configured to selectively connect the second bit line (BL1_C2) of the second string (STR1_C2) and a second sensing node according to a second bit line connection control signal (CLBLK_C2), and
wherein the control logic circuit (1170) is further configured to, in the read operation mode, control a first sensing time (T3) during which the first bit line connection control signal (CLBLK_C1) is activated to be different from a second sensing time (T4) during which the second bit line connection control signal (CLBLK_C2) is activated.

15. A method of operating a memory device which includes a memory cell array (1110) including a first string (STR1_C1) provided in a first layer (CL1) and a second string (STR1_C2) provided in a second layer (CL2) stacked on the first layer (CL1), the method comprising:
entering a core operation mode; and
independently controlling a first page buffer (PB1) connected to the first string (STR1_C1) of the first layer (CL1) and a second page buffer (PB2) connected to the second string (STR1_C2) of the second layer (CL2), based on a characteristic difference of the first layer (CL1) and the second layer (CL2).
